(19) Europäisches Patentamt
European Patent Office
Office européen des brevets

(11) EP 2 243 859 A1

(12) EUROPEAN PATENT APPLICATION
published in accordance with Art. 153(4) EPC

(43) Date of publication:
27.10.2010 Bulletin 2010/43

(51) Int Cl.:
C23C 16/56 (2006.01)    C23C 16/509 (2006.01)
C23C 16/54 (2006.01)

(21) Application number: 09713077.7

(22) Date of filing: 21.01.2009

(86) International application number:
PCT/JP2009/050819

(87) International publication number:
WO 2009/104443 (27.08.2009 Gazette 2009/35)

(84) Designated Contracting States:
AT BE BG CH CY CZ DE DK EE ES FI FR GB GR
HR HU IE IS IT LI LT LU LV MC MK MT NL NO PL
PT RO SE SI SK TR
Designated Extension States:
AL BA RS

(30) Priority: 19.02.2008 JP 2008037356

(71) Applicant: Konica Minolta Holdings, Inc.
Tokyo 100-0005 (JP)

(72) Inventor: OISHI, Kiyoshi
Hino-shi
Tokyo 191-8511 (JP)

(74) Representative: Gille Hrabal Struck Neidlein Prop
Roos
Patentanwälte
Brucknerstrasse 20
40593 Düsseldorf (DE)

(54) THIN FILM FORMING METHOD AND THIN FILM STACK

(57) Provided are a thin film forming method capable of stably forming a homogeneous film at high productivity and a thin film stack obtained thereby. In the thin film forming method, a first discharge space for forming a functional film on a base material under an atmospheric pressure or a pressure near the atmospheric pressure and a second discharge space for post-treating the base material on which the film is formed in the first discharge space are provided. The first discharge space is composed of a pair of roll electrodes and used in a film forming step of forming the functional film on the base material by supplying a mixed gas (1) containing a discharge gas and a thin film forming gas to the first discharge space from a mixed gas supply means to form a high-frequency electric field between the pair of roll electrodes. The second discharge space is located at the outer periphery of one of the roll electrodes and used in a post-treatment step of performing post-treatment by introducing the base material on which the functional film is formed thereinto and introducing a mixed gas (2) containing the discharge gas and a post-treatment gas between a counter electrode and the roll electrode to form a high-frequency electric field between the counter electrode and the roll electrode.

FIG. 1

**Description**

**TECHNICAL FIELD**

This invention relates to a method for forming a thin film by a plasma treatment system under the atmospheric pressure or a pressure near atmospheric pressure.

**TECHNICAL BACHGROUND**

Recently, various materials each composed of a substrate and a highly functional thin film such as an electrode film, dielectric protective film and a semiconductor film are frequently used in various products such as a LSI, semiconductor, displaying device, magnetic recording device and photo-electrical converter device.

For forming such the highly functional thin films, a wet film forming method typified by a coating method or a vacuum deposition method, a spattering method, an ion beam method, an ion plating method and a plasma-chemical vapor deposition (CVD) method using glow discharge under reduced pressure have been applied. These methods, however, each composed of a vacuum treating means. Therefore, the treatment system is necessarily made vacuum to enough degree so that the mechanical device units to be equipped in the film forming apparatus should be made to large-scale such as a large treatment chamber and a large vacuum pump, and complicated works under highly reduced pressure are required. Moreover, the various conditions such as the diameter and the width of the rolled substrate and the volume of the raw materials for thin film formation are limited by the properties of these apparatus and the device units.

As the countermeasure to such problems, for example, an atmospheric pressure plasma discharge treatment thin film forming method is contrived and made practicable since the thin film having higher properties than that formed by the wet film forming method and higher production efficiency than the dry film forming method using the vacuum, can be obtained by such the method. The atmospheric pressure plasma discharge treating method has the advantage that the continuous film formation can be performed as the same as in the coating method because the vacuum is not necessary.

In the apparatus to be used for the continuous surface treatment or the continuous thin film formation using the atmospheric pressure, a pair of parallel planar electrodes is used as the plasma treatment electrodes, each of which is smoothly rounded on the edge for preventing the point discharge.

This method is superior because such the parallel planar electrodes are easy in the production and setting the electrode distance and the area of the electrode can be made wide; therefore, the film to be treated which is transported between the electrodes is successively treated along the transporting direction so that the thin film formation speed can be raised, moreover, the plasma treating gas density can be made higher than the forgoing reduced pressure plasma. On the other side, however, the cost of the apparatus such as the electrodes is high. Accordingly, it is the key for practically using the method that the reduction of the cost of the apparatus or cost reduction by the raising of treating ability. Furthermore, rising of energy such as increasing in the plasma density or in the electric field strength is considered. However, there is the possibility of concentrated arc discharge of large current in such the case.

Furthermore, the foregoing electrodes have problems, since the forgoing electrodes are fixed electrodes, that the surface of the electrodes are gradually contaminated because they are always exposed to the gas mixture flow for forming the film and the discharge is continuously preformed, and the plasma discharge is varied at last, as a result of that the properties of the formed film or the treated surface are fluctuated and a defect apparently recognized by visual such as a line or ununiformity is finally caused in remarkable case.

For preventing the above contamination of the electrodes, a discharging plasma method is proposed, in which the gas mixture is supplied between roller-shaped discharging plasma treatment electrodes; cf. Patent Documents 1 to 3, for example.

The discharge plasma system using the roller electrodes can continuously form the functional thin film on the flexible substrate such as a plastic substrate at high product efficiency. From the viewpoint of high product efficiency, the high quality functional thin film can be formed at high transportation speed by increasing the plasma applying energy to the discharging space by raising the voltage applying to the facing roller electrodes. However, in the discharging space formed by the facing electrodes, the distance between the electrodes is extended along the direction of from the center to the circumference of the facing roller electrode so that the discharge density is made higher in the area where the electrode distance is narrow and is made lower at the peripheral portion where the electrode distance is wide; therefore, the strength of discharge is made ununiform when the increased energy is applied between the facing roller electrodes. Thus the formation of the thin film with uniform quality is made difficult.

Patent Document: JP-A-2003-93870
Patent Document: JP-A-2004-189958
Patent Document: JP-A-2007-87788

## DISCLOSURE OF THE INVENTION

### PROBLEMS TO BE SOLVED

This invention is attained on the above-mentioned base, and an object of that is to provide a thin film forming method capable of stably forming the thin film with uniform quality at high production efficiency and a thin film stack formed by the method.

### MEANS FOR SOLVING THE PROBLEMS

The object of the invention can be attained by the following constitution.

1. A thin film forming method for forming a thin film onto a substrate by a plasma discharging treatment under atmospheric pressure or near atmospheric pressure comprising;
a first discharging space forming a functional thin film on the substrate, and
a second discharge space post-treating the substrate, on which formed the thin film in the first discharge space,
the first discharge space is the thin film forming process, which is constituted by at least one pair of roller electrodes, and transports the substrate while holding by winding on the surface of each of the roller electrodes and supplies mixed gas 1 containing discharging gas and thin film forming gas into the first discharging space from a mixed gas supplying section, and generates high frequency electric field between each of the roller electrodes to form the functional film on the substrate,
the second discharge space is the post-treatment process, which is positioned on the periphery of at least one of the roller electrodes and, introduces the substrate on which the functional film is formed, and supplies the mixed gas 2 containing the discharging gas and post-treatment gas between the facing electrodes and generates a high frequency electric field between the facing electrode and the roller electrode to perform the post-treatment.
2. The thin film forming method of claim 1, wherein the discharging gas is nitrogen.
3. The thin film forming method of claim 1 or 2, wherein the post-treatment gas in the post-treatment process is oxidizing gas to form a metal oxide film.
4. The thin film forming method of claim 1 or 2, wherein the post-treatment gas in the post-treatment process is reducing gas to form a metal film.
5. The thin film forming method of any one of claims 1 to 4, wherein the plasma discharging treatment under atmospheric pressure or near the atmospheric pressure in the first discharge space is carried out by a plasma discharging method in which a first high frequency electric field and a second high frequency electric field are overlapped between the pair of the roller electrodes.
6. The thin film forming method of any one of claims 1 to 5, wherein the plasma discharging treatment under atmospheric pressure or near the atmospheric pressure in the second discharge space is carried out by a plasma discharging method in which a first high Frequency electric field and a second high frequency electric field are overlapped between the facing electrode and the roller electrode.
7. The thin film forming method of any one of claims 1 to 6,wherein the supply of the mixed gas into the first discharge space is carried out through an assistant blowing section together with the mixed gas supplying section.
8. The thin film forming method of any one of claims 1 to 6, wherein the method has a blade which is attached at a portion being between the mixed gas supplying section and the roller electrode of the first discharging space, which is touched to the outer peripheral surface of the roller electrode at one end and fixed on the mixed gas supplying section at the other end.
9. The thin film forming method of any one of claims 1 to 6, wherein the method has a rotatable nip roller which are touched each other, and has a blade which is touched to the nip roller at one end and fixed on the mixed gas supplying section at the other end to a portion being between the mixed gas supplying section of the first discharging space and the roller electrode.
10. The thin film forming method of any one of claims 1 to 9, wherein the method has a structure for changing the position of the second discharging space so that the formation of the thin film is performed by reversing the transportation direction of the substrate.
11. A film stack formed by the thin film forming method described in any one of claims 1 to 10.

### EFFECTS OF THE INVENTION

The thin film forming method by which the uniform quality thin film can be stably formed at high production efficiency and the thin film stack produced by such the method can be provided by the invention.

**BRIEF DESCRIPTION OF THE DRAWINGS**

Fig. 1 shows a schematic drawing of an example of plasma discharge treating apparatus applicable for the thin film forming method of the invention.

Fig. 2 shows a schematic drawing of a plasma discharge treating apparatus for performing the thin film formation and the post-treatment while continuously loop transporting the substrate.

Fig. 3 shows a schematic drawing of a plasma discharge treating apparatus for performing the thin film formation and the post-treatment while continuously loop transporting two line of substrate for each of the roller electrodes.

Fig. 4 shows a schematic drawing of an example of plasma discharge treating apparatus relating to the invention in which the substrate is treated by using roller electrodes to which the first high frequency electric field and the second high frequency electric field are applied in overlap.

Fig. 5 shows a schematic drawing of another example of plasma discharge treating apparatus relating to the invention by which the substrate is treated by using a roller electrode to which the first high frequency electric field and the second high frequency electric field are applied in overlap.

Fig. 6 shows a schematic drawing of a plasma discharge treating apparatus in which the first high frequency electric field and the second high frequency electric field are applied in overlap while continuously loop transporting the substrate.

Fig. 7 shows a schematic drawing of an example of gas supplying means applicable for the plasma discharge treating apparatus relating to the invention.

Fig. 8 shows a schematic drawing of another example of gas supplying means applicable for the plasma discharge treating apparatus relating to the invention.

Fig. 9 shows a schematic drawing of another example of gas supplying means applicable for the plasma discharge treating apparatus relating to the invention.

Fig.10 shows a perspective drawing of a roller electrode applicable for the invention.

Fig.11 shows a perspective drawing of an example of square pillar-shaped fixed electrode applicable for the invention.

**DESCRIPTION OF SYMBOLS**

1: Atmospheric pressure plasma discharging apparatus
10A, 10B, 302: Roller electrode
11A, 11B, 11C, 11D: U-turn roller
11E, 11F: Support roller
100, 300: Discharger
20, 21: Guide roller
200a, 200A: Electro-conductive mother material
200b: Ceramic coated dielectrics
200B: Lining treated dielectrics
30: Treating gas supplying means
301: Fixed electrode
31: Nip roller
32: Blade
40: Exhausting opening
80: Power source
801: First power source
802: Second power source
81, 82, 811, 812, 822: Voltage supplying means
831: First filter
832: Second filter
CG: Assistant gas
F: Substrate
G: Reacting gas
G': Gas after treatment

## PREFERRED EMBODIMENTS OF THE INVENTION

Preferred embodiments of the invention are described in detail below.

As a result of investigation by the inventors regarding to the above object, it is found that the thin film forming method capable of stably forming a uniform quality film at high product efficiency can be realized by the following method; a method for forming a thin film on a substrate by plasma discharge treatment under atmospheric pressure or near atmospheric pressure in which the apparatus for performing the method has a first discharging space for forming a functional thin film on a substrate and a second discharging space for post-treating the substrate on which the thin film is formed in the first discharging space, and the first discharging space is a film forming process constituted by at least one pair of roller electrodes, in which the substrate is transported by drawing around the roller while holding on the surface of the pair of electrodes, and mixed gas 1 containing discharging gas and thin film forming gas is supplied through a mixed gas supplying means, and then a high frequency electric field is generated between the roller electrode of the pare to form the functional thin film of the substrate. And the second discharging space is the post-treating process positioned on the outer periphery of the at least one of the roller electrodes in which the substrate carrying the functional thin film is introduced and mixed gas 2 containing the discharging gas and post-treating gas is introduced and a high frequency electric field is generated between the facing roller and the roller electrode to perform the post-treatment. Thus the present invention is attained.

As above-described, the discharging strength is made ununiform accompanied with the variation of the discharging distance when high energy is applied between the facing roller electrodes so that the functional film having uniform quality in the film surface direction is difficultly formed. The inventors investigate regarding the formation of uniform film by the plasma discharge treating method under atmospheric or near atmospheric pressure. As a result of that, it is found that the functional film having extremely high quality and uniformity can be obtained at high product efficiency when the film is formed in the film forming process under a discharging energy condition in the degree of not causing ununiformity in the film quality, and there-filling of the film is accelerated in the post-treating process to make higher the density of the film so as to raise the properties thereof. In the invention, the functional film include, for example, an electrode film, dielectrics protection film, semiconductor film, transparent electro-conductive film, electrochromic film, fluorescent film, superconductive film, dielectric film, solar cell film, antireflection film, anti-wearing film, light interference film, reflection film, antistatic film, electro-conductive film, anti-contamination film, hard-coat film, subbing film, barrier film, magnetic radiation shading film, infrared shading film, UV-absorbing film, lubricant film, shape memory film, magnetic recording film, light emission element film, bio-adaptation film, ant-corrosion film, catalyst film, gas sensor film and decoration film.

Details of the thin film forming method and the thin film stack of the invention are described below.

[Plasma discharge treating apparatus]

Firstly, the plasma discharge treating apparatus to be used in the invention is described referring the drawings, but the plasma discharging apparatus in the invention is not limited to them.

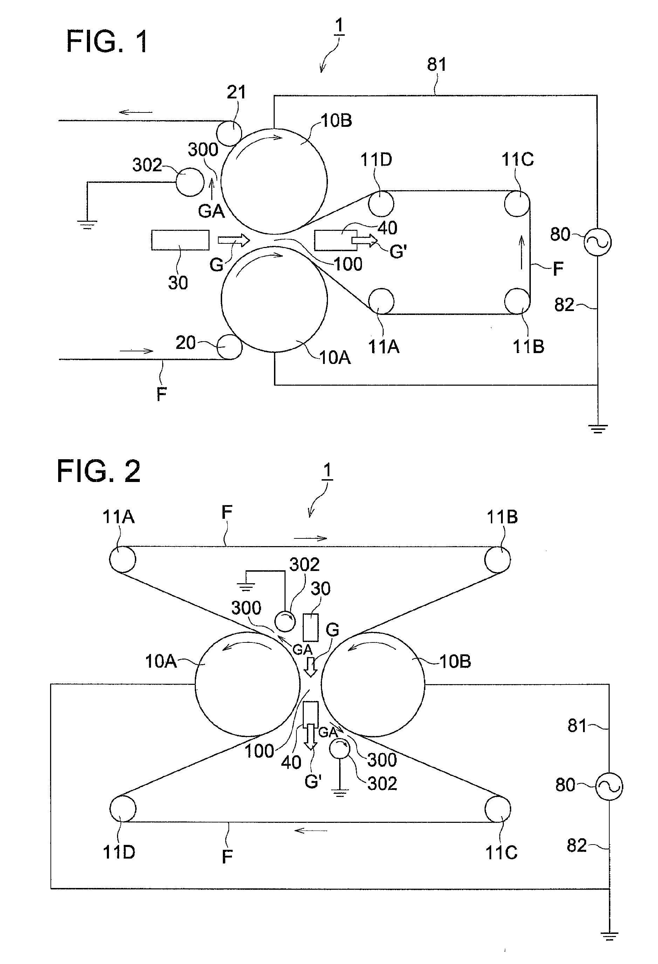

Fig. 1 shows a schematic drawing of an example of plasma discharge treatment apparatus applicable for the thin film forming method of the invention.

In the plasma discharge treating apparatus 1, the first film forming process has a pair of a roller electrode 10A and a roller electrode 10B, and a power source 80 capable of applying voltage for plasma discharge is connected to the electrodes 10A and 10B through voltage supplying means 81 and 82. The roller electrodes 10A and 10B are rotating electrodes capable of rotating while drawing around the substrate F. Discharging portion (also referred to as discharging space) 100 is held at atmospheric or near atmospheric pressure, and mixed gas 1(G) containing discharging gas and thin layer forming gas is supplied to the discharging portion through a treatment gas supplying portion 30" then the plasma discharging is carried out in the discharging portion 100.

The substrate supplied from a previous process or a bulk roll is contacted with the roller electrode 10A by a guide roller 20 and synchronously transported by rotation, and subjected to the plasma discharging treatment by the mixed gas 1(G).

The gas supplying means 30 is preferably a slit having a width of the same as or a little wider than that of the substrate, and may be one constituted by pipe-shaped blowing openings lined in the width direction by the almost the same width of the substrate, and it is preferable that the mixed gas 1 (G) is introduced into the discharging portion 100 at uniform flowing amount or rate along the whole width direction. The substrate F treated once is transported in the reverse direction through turning rollers (also referred to as U-turn rollers) 11A, 11B, 11C and 11D and held by the roller electrode 10B and then again subjected to the plasma discharging treatment in the discharging portion 100.

In the post-treating process as the second process, a roller electrode 302 is arranged as a facing electrode on the downstream side of the discharging portion 100 of the roller electrode 10B, and voltage for plasma discharge is applied between a fixed electrode 301 and the roller electrode 10B to constitute a discharging portion 300 as the second discharging space. To the discharging space 300, mixed gas 2 (GA) containing the discharging gas and the post-treating gas is introduced and the post-treatment to the functional thin film, which is formed by suitable discharging energy condition in the first film forming process, is carried out to prepare the high quality functional thin film excellent in the uniformity. In Fig.1, the roller electrode 302 is displayed as an example of the facing electrode constituting the discharging space 300: however, a parallel planar electrode (a square pillar-shaped electrode) and a rod-shaped electrode are applicable.

After that, the post-treated substrate F is winded up through a guide roller 21 or transported to a next process (not shown in the drawing).

In the first film forming process, the gas after treatment is exhausted through an exhausting opening 40. The flowing amount of the exhausted gas from the exhausting opening 40 is preferable the same or larger a little compared with that of the mixed gas from the mixed gas supplying means 30. It is also allowed to shade the both sides of the roller electrodes 10A and 10B of the discharging portion 100, or to entirely cover the apparatus and wholly fill by rare gas or the treating gas.

The plasma discharge treating apparatus shown in Fig.1 displays the system in which the substrate F treated in the discharging portion 100 is transported in the reverse direction through the turning rollers 11A, 11B, 11C and 11D, and received the second plasma discharging treatment in the discharging portion 100 while holding by the roller electrode 10B, and then post treated in the discharging portion 300 constituting the post-treating process, after that the substrate is wound up or transported to the next process (both of them are not shown in the drawing) through the guide roller 21. In another system, one of preferable embodiments, an endless substrate is held by the turning rollers 11A, 11B, 11C and 11D and subjected to formation of the functional thin film and the post-treatment while continuously transported by the loop transportation.

Fig. 2 shows a schematic drawing a plasma, discharge treating apparatus in which the thin film formation and the post-treatment are carried out while continuously transporting the substrate by the loop transportation method on each of the roller electrodes.

In the first film formation process in the plasma discharge treating apparatus 1, the endless substrate F held by the turning rollers 11A, 11B, 11C and 11D so that the thin film forming surface is inside, and continuously transported. The roller electrode 10A and the roller electrode 10B are arranged so as to be faced with together to constitute the discharging portion 100 as the first discharging space.

The power source 80 capable of supplying voltage for plasma discharge is connected to each of the roller electrodes 10A and 10B through voltage supplying means 81 and 82. The roller electrodes 10A and 10B are each a rotatable electrode capable of rotating while drawing around the substrate F, and the pressure in the discharging portion is held at the atmospheric or near atmospheric pressure. Mixed gas 1 (G) containing the discharging gas and the thin film forming gas is supplied from the treating gas supplying portion 30, and the plasma discharge is performed in the discharging portion 100 as the first discharging space. Gas G' after the treatment is exhausted through the exhausting opening 40.

As the second post-treating process for the substrate F on which the functional thin film is formed in the discharging portion 100, facing electrodes are each arranged at the downstream side of the rotating direction of the roller electrodes 10A and 10B (in Fig. 2, an example using roller electrodes 302 is shown), and a discharging portions 300 as the second discharging spaces are constituted by applying voltage for plasma discharge between the roller electrodes 302 and the roller electrodes 10A and 10B. mixed gas 2 (GA) containing the discharging gas and post-treating gas is introduced into the discharging portions 300, and the functional thin film formed under the suitable discharging energy condition in the first film forming process is subjected to the post-treatment to prepare the high quality functional thin film excellent in the uniformity.

In the invention, the turning transportation mechanism as shown in Fig. 1 and the plasma discharging treating apparatus having the loop transportation mechanism as shown in Fig. 2 are preferable since the ununiformity caused by the different roller electrodes can be canceled by that the substrate is passed on the surface of the roller electrodes different form each other so that the functional thin film having higher uniformity can be obtained.

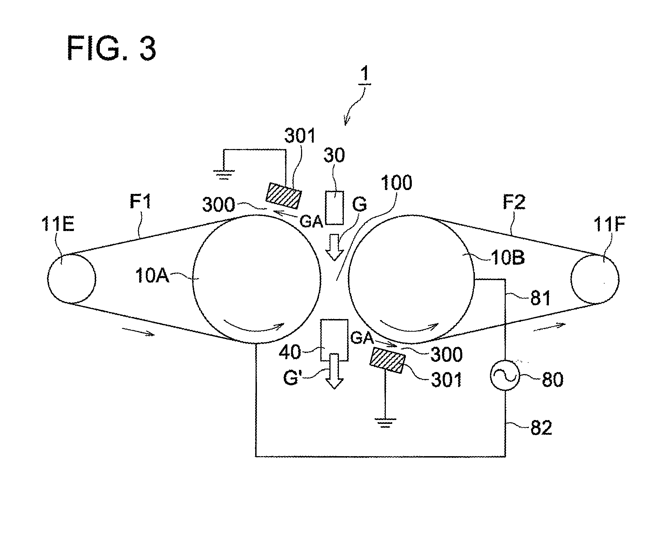

In Figs. 1 and 2, examples of the thin film forming method using one substrate is shown; however, the method shown in Fig. 3 may be applied in which different substrates F1 and F2 continuously transporting on the each of the roller electrodes 10A and 10B, respectively, through support rollers 11E and 11F each corresponding to the roller electrodes, are simultaneously subjected to the functional thin film formation and the post-treatment.

The thin film formation method of the invention is performed under the atmospheric or near atmospheric pressure. In such the method, high production efficiency can be obtained since pressured reduction is not required compared with the plasma CVD method performed under vacuum. Moreover, the film forming rate is high because the plasma density is high, and the film having excellent uniformity can be obtained since the average free process is very short under the high pressure condition such as atmospheric pressure compared with the condition of usual CVD method.

In the invention, the near atmospheric pressure is a pressure of from 20 kPa to 110 kPa, and that of from 93 kPa to 104 kPa is preferable for obtaining satisfactory effect of the invention.

In Figs. 1 and 2, the plasma discharge treating apparatus is described, in which the high frequency power source 80 for supplying the voltage for plasma discharge is installed and the same voltage with single frequency band is applied to both of the roller electrodes 10A and 10B. However, in the plasma discharge treating apparatus of the invention, the method is one of more preferable embodiments, in which power sources different in the frequency from each other are respectively, provided for each of the roller electrodes so as to overlap the first electric field and the second electric field for performing the plasma discharge. In the invention, the system having the single power source 80 capable of supplying voltage for the plasma discharge having single frequency band is referred to as voltage applying system A. The latter system having the power sources different from each other in the frequency for respective the roller electrode so that the first high frequency electric field and the second electric field are overlapped for causing the plasma discharge, is referred to as voltage applying system B.

In the voltage applying system B of the invention where the first high frequency electric field and the second high frequency electric field are overlapped with together for performing the plasma discharge, high frequency voltage is applied between the first and second roller electrodes, and the high frequency voltage at least contains a constituent generated by overlapping the a voltage constituent of the first frequency $\omega_1$ and a voltage constituent of the second frequency $\omega_2$ higher than that of the first frequency $\omega_1$.

The high frequency is one having a Frequency not less than 0.5 kHz. The high frequency voltage is composed of the constituent formed by overlapping the first voltage constituent of frequency $\omega_1$ and the second voltage constituent of frequency $\omega_2$ higher than the first frequency the first voltage constituent of frequency $\omega_1$, and the wave shape thereof becomes corrugated sine wave of $\omega_1$ formed by overlapping the sine wave of $\omega_2$ higher than $\omega_1$ on the sine wave of the frequency $\omega_1$.

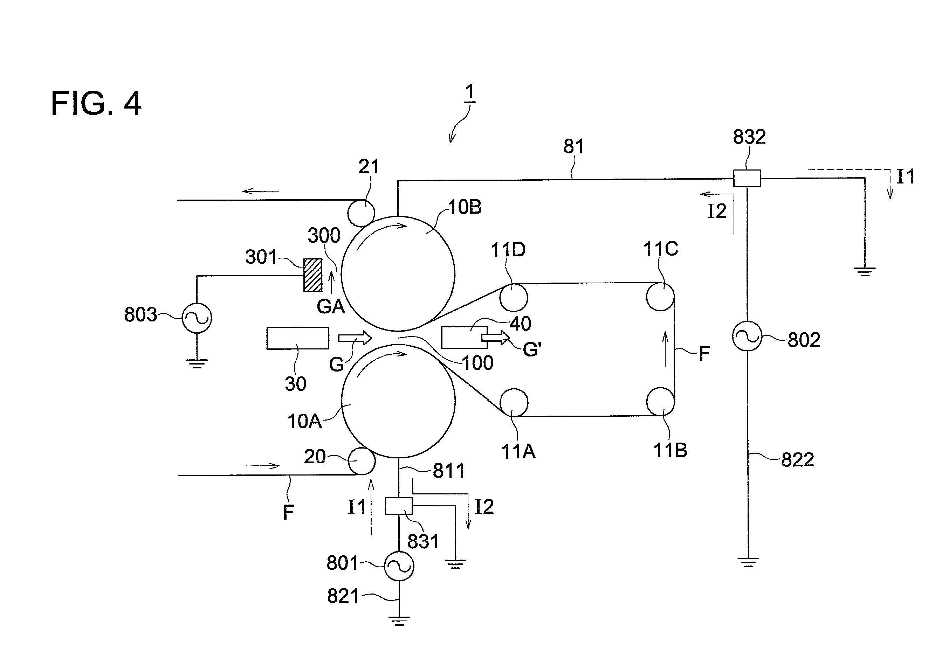

Fig. 4 shows a schematic drawing of an example of the plasma discharge treating apparatus related to the invention, in which the substrate is treated by using the roller electrodes of the voltage applying system B for overlapping the first and second high frequency electric fields.

In the plasma discharge treating apparatus 1, the film forming process has the roller electrode 10A (first electrode) and the roller electrode 10B (second electrode). To the roller electrode 10A, the first power source 801 capable of applying high frequency voltage $V_1$ having frequency of $\omega_1$ for plasma discharge is connected through a voltage supplying means 811. To the roller electrode 10B, the second power source 802 capable of applying high frequency voltage $V_2$ having frequency of $\omega_2$ for plasma discharge is connected through a voltage supplying means 812. The first power source 801 preferably has ability of applying a high frequency voltage higher than that of the second power source ($V_1 > V_2$), and relation of the first frequency $\omega_1$ of the first power source 801 and the second frequency $\omega_2$ of the second power source 801 is preferably $\omega_1 < \omega_2$. A first filter 831 is provided between the roller electrode 10A and the first power source 801 so as to easily pass the electric current from the first power source 801 to the roller electrode 10A. The first filter is designed so that the electric current $I_1$ from the first power source 801 is difficultly passed to the ground and easily current and the electric current $I_2$ from the second power source 802 is easily passed to the ground. A second filter 832 is provided between the roller electrode 10B and the second power source 802 so as to easily pass the electric current from the second power source 802 to the roller electrode 10B. The second filter is designed so that the electric current $I_2$ from the second power source 802 is difficultly passed to the ground and easily current and the electric current $I_1$ from the first power source 801 is easily passed to the ground.

As another discharging condition in the invention, a condition in which the high frequency voltage formed by overlapping a first high frequency voltage $V_1$ and a second high frequency voltage $V_2$ is applied between the first electrode and the second electrode facing to each other, and the relation of $V_1$ and $V_2$ preferably satisfies $V_1 \geq IV > V_2$ or $V_1 > IV \geq V_2$, and more preferably $V_1 > IV > V_2$, when IV is the discharge beginning voltage.

As the frequency of the first power source is preferably not more than 200 kHz, and the wave shape if it may be sine wave or pulse wave. The lower limit is desirably approximately 1 kHz.

The frequency of the second power source is preferably 800 kHz or more.

Higher frequency of the second power source results higher plasma density, and dense and high quality thin film can be obtained. The upper limit is desirably not less than 200 MHz.

In the invention, as the electric power to be applied to the facing electrodes, an electric power (output density) of not less than 1 W/cm$^2$ is applied to the second electrode for exciting the discharging gas to generate the plasma by donating the energy to the thin film forming gas for forming the thin film. The upper limit of the electric power to be applied to the second electrode is preferably 50 W/cm$^2$, and more preferably 20 W/cm$^2$. The lower limit is preferably 1.2 W/cm.$^2$ The discharging area (cm$^2$) is the area of the electrode where the discharge is performed.

The output density can be raised while maintaining the uniformity of the second electric field by also supplying an electric power (output density) of not less than 1 W/cm$^2$ to the first electrode (the first electric field). By such the method, the uniform plasma with higher density can be generated so that further rising in the film forming speed and the film quality can be compatible. The electric power to be supplied to the first electrode is preferably not less than 5 W/cm$^2$ and the upper limit of that is preferably 50 W/cm$^2$.

For the secondary post-treatment after formation of the functional thin film on the substrate by the above method, a facing electrode (in Fig. 4, an example using a fixed electrode 301 is displayed) is arranged on the downstream of the same periphery, and voltage for plasma discharge is applied between the fixed electrode 301 and the roller electrode 10B to form a discharging portion 300 as the second discharging space. Mixing gas 2 (GA) containing the discharging gas and the thin film forming gas is introduced into the discharging portion 300 to perform the post-treatment to the thin film formed by in the first film forming process under the suitable discharging energy condition for preparing the high quality functional thin film excellent in the uniformity. In the invention, a method in which the first high frequency electric field and the second electric field are supplied in overlap to the same electrode may be applied.

Although the example using the voltage applying system B, in which the first high frequency electric field and the second high frequency electric field are applied in overlap, is displayed in Fig. 4, the voltage applying system A only using the single power source is also applicable.

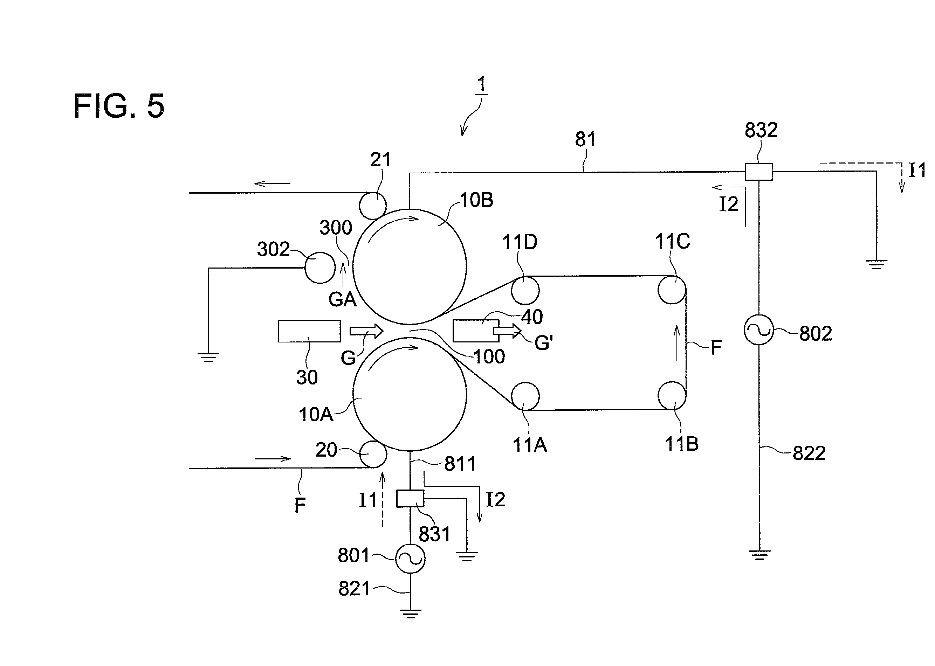

Fig. 5 is the schematic drawing of another example of the plasma discharging treatment of the invention for treating the substrate using the roller electrode of the voltage applying system B.

Although the plasma discharge treating apparatus shown in Fig. 5 is the system similar to that shown in Fig. 4, the method for plasma treatment is displayed, in which the roller electrode 302 is used for the post-treatment and the voltage applying system A only using the single power source..

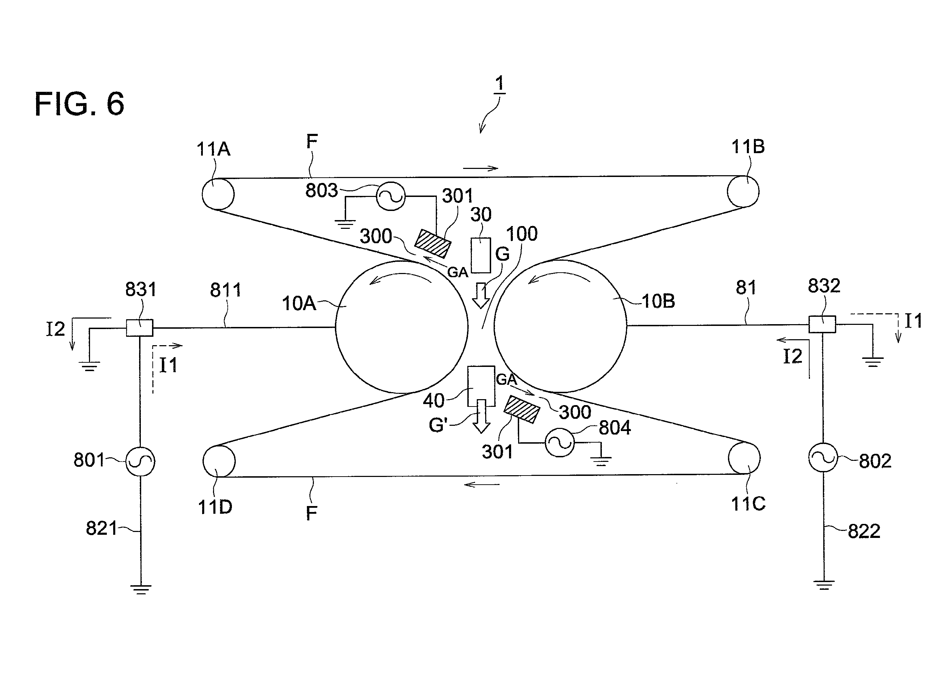

Fig. 6 shows a constitution of the plasma discharge treating apparatus for performing the thin film formation and the post-treatment while continuously transporting the substrate by using the voltage applying system B as the power source. The volt applying method is the same constitution as that described in Fig. 4.

As the first power source 2 (high frequency power source), the followings can be cited, which are available on the market and all usable.

| Symbol of power source | Manufacturer | Frequency | Product name |
|---|---|---|---|
| A1 | Shinko Electric Co. | 3 kHz | SPG3-4500 |
| A2 | Shinko Electric Co. | 5 kHz | SPG5-4500 |
| A3 | Kasuga Electic Works Ltd. | 15 kHz | AGI-023 |
| A4 | Shinko Electric Co. | 50 kHz | SPG50-4500 |
| A5 | Haidenraboratory | 100 kHz* | PHF-6k |
| A6 | Pearl Kogyo Co., Ltd. | 200 kHz | CF-2000-200k |

As the second power source (high frequency power source), the followings can be cited, which are available on the market and all usable.

| Symbol of power source | Manufacturer | Frequency | Product name |
|---|---|---|---|
| B1 | Pearl Kogyo Co., Ltd. | 800 kHz | CF-2000-800k |
| B2 | Pearl Kogyo Co., Ltd | 2 MHz | CF-2000-2M |
| B3 | Pearl Kogyo Co., Ltd. | 13.56 MHz | CF-5000-13M |
| B4 | Pearl Kogyo Co., Ltd. | 27 MHz | CF-2000-27M |
| B5 | Pearl Kogyo Co., Ltd. | 150 MHz | CF-2000-150M |
| B6 | Pearl Kogyo Co., Ltd. | 20-99.9 MHz | RP-2000/100M |

Among the above power sources, one having an asterisk is an impulse high frequency power source (100 kHz in continuous mode) manufactured by Haidenraboratory. The other of them are the power sources capable of applying continuous sine wave.

[Gas supplying means]

In the more preferable embodiment of the plasma discharge treating apparatus, the apparatus has the following various gas supplying means for stably forming the uniform functional thin film.

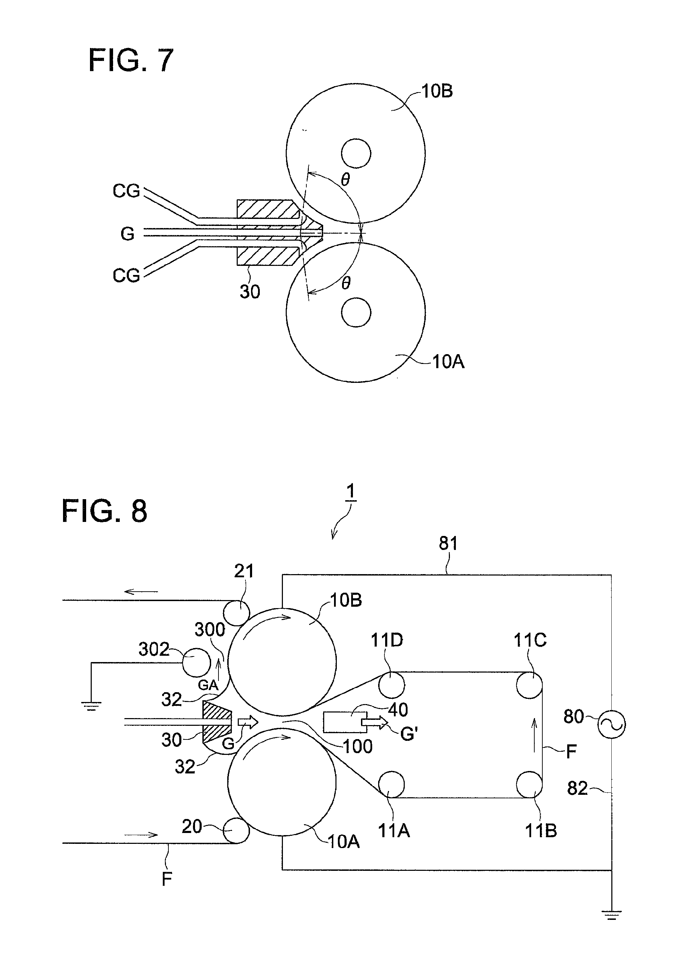

Fig. 7 shows a schematic drawing of an example of the gas supplying means applicable for the plasma discharge treating apparatus relating to the invention.

In the above drawings, the mixed gas 1 (G) is blown in the direction of the gap between the roller electrode 10A and the roller electrode 10B; however, the blown treating gas cannot be always wholly passed through the gap when the gap is narrow and a part of the mixed gas is leaked out through the gap between the gas supplying means 30 and the roller electrode to the outside so that the treatment gas is excessively needed and fills in the treatment chamber. So, it is apprehensive to give bad influence to human body according to the kind of the gas.

In the embodiment of the plasma discharge treating apparatus relating to the invention, it is preferable for solving the above problem to provide a an assistant gas (CG) blowing opening at the mixed gas supplying means 30 as the means for cutting off the leaked mixed gas 1, as shown in Fig. 7.

The mixed gas 1 (G) is composed of the discharging gas and the thin film forming gas, the discharging gas is an inactive gas such as rare gas and nitrogen, and the thin film forming gas is composed of raw material gas to be the raw material for depositing the thin film and a reacting gas for accelerating the decomposition. The assistant gas CG is composed of an inactive gas such as a rare gas and nitrogen, and preferably the same as the discharging gas contained in the discharging gas or the discharging and the reacting gas.

The blowing rate of the assistant gas is preferably within the range of from 1 to 5 times of that of the mixed gas 1 (G) at the exit of the mixed gas supplying means. The effect of the assistant gas is insufficient when the blowing rate is less than the above, and the mixed gas 1 (G) is difficultly supplied to the discharging space 100 when the ratio is not less than 5.

The effect of the assistant gas CG can be obtained and the entering of air accompanied through the gap between the side of the mixed gas supplying means 30 and the roller electrode 10A and 10B can be prevented by setting the angle θ made by the blowing exit for blowing the assistant gas CG to the roller electrodes 10A and 10B and the blowing direction of the treating gas G to be within the range of $0° \leq θ < 90°$, preferably $0° \leq θ < 60°$, and more preferably $0° \leq θ < 30°$. When the angle is more than 90°, the ingredient of the assistant gas CG blowing to the discharging space 100 is decreased so that the effect cannot be obtained. Here, the θ is the angle made by the direction of blowing of the mixed gas 1 and that of the assistance gas. The material of the gas supplying means 30 supplying the mixed gas 1 (G) and the assistant gas CG is preferably made from ceramics such as alumina or an insulating material such as resin, and particularly heat resistive resin such as (poly(ether ether ketone)) is preferred.

Fig. 8 shows a schematic drawing of another example of gas supplying means applicable to the plasma discharge treating apparatus relating to the invention.

The plasma discharge treating apparatus 1 shown in Fig. 8 is almost the same as that shown in Fig.1 in the basic constitution and a constitution is newly added to the mixed gas supplying means 30. In Fig. 8, a blade 32 is provided to each of the roller electrodes as the means for cutting the leaked mixed gas 1 (G); the blade has a width equal of more of that of the mixed gas supplying means 30 and is touched with the outer peripheral surface of the roller electrode 10A or 10B at one end thereof and fixed on the mixed gas supplying means 30.

The blade 32 applicable to the invention is further described below. The blade 32 is made from insulating resin or rubber. As the resin, the followings are usable; polyolefin (PO) resin such as homo- or co-polymer of monomer such as ethylene, polypropylene and butene, amorphous polyolefin (APO) resin such as poly(cyclic olefin), polyester resin such as poly(ethylene terephthalate) (PET) and poly(ethylene 2,6-naophthalate) (PEN), polyamide (PA) type resin such as Nylon 6, Nylon 12 and copolymerized nylon, poly(vinyl alcohol) type resin such as ethylene-vinyl alcohol copolymer (EVOH), poly(vinyl alcohol) (PVA) resin, polyimide (PI) resin, polyetherimide (PEI) resin, polysulfone (PS) resin, polyethersulfone (PES) resin, poly(ether ether ketone) (PEEK) resin, polycarbonate (PC) resin, poly(vinyl butylate) (PVB) resin, polyallylate (PAR) resins and fluorine type resin such as ethylene ethylenetetrafluoride copolymer (ETFE), trifluoroethylene chloride (PFA), tetrafluoroethylene perfluoroalkylvinyl ether copolymer (FEP), vinylidiene fluoride (PVDF), vinyl fluoride (PVF) and perfluoroethylene-perfluoropropylene-perfluorovinyl copolymer (EPA). Particularly, heat-resistive resins such as polycarbonate, polyethersulfone, poly(ether ether ketone) and polyimide are preferably used. The insulation ability of the blade is preferably not less than $10^{10}$ Ωcm, and more preferably not less than $10^{12}$ Ωcm.

As the material of the rubber, chloroprene rubber, fluoro rubber and silicone rubber are cited, which are excellent in the anti-wearing, anti-weather and anti-aging properties. Fluoro rubber having low gas permeation property is particularly preferred. The hardness of the rubber is preferably from 60 to 85 degree (according to JIS K 6253-1997).

The end of the blade 32 has rounded across section so that the formed thin film is not damaged by the touching with the end of the blade. As shown in Fig. 8, the shape of the blade touching with the outer periphery of the roller electrode 10A and that of the blade touching with the outer periphery of the roller electrode 10B are both in the shape of pulled state in the rotating direction of each of the roller electrodes.

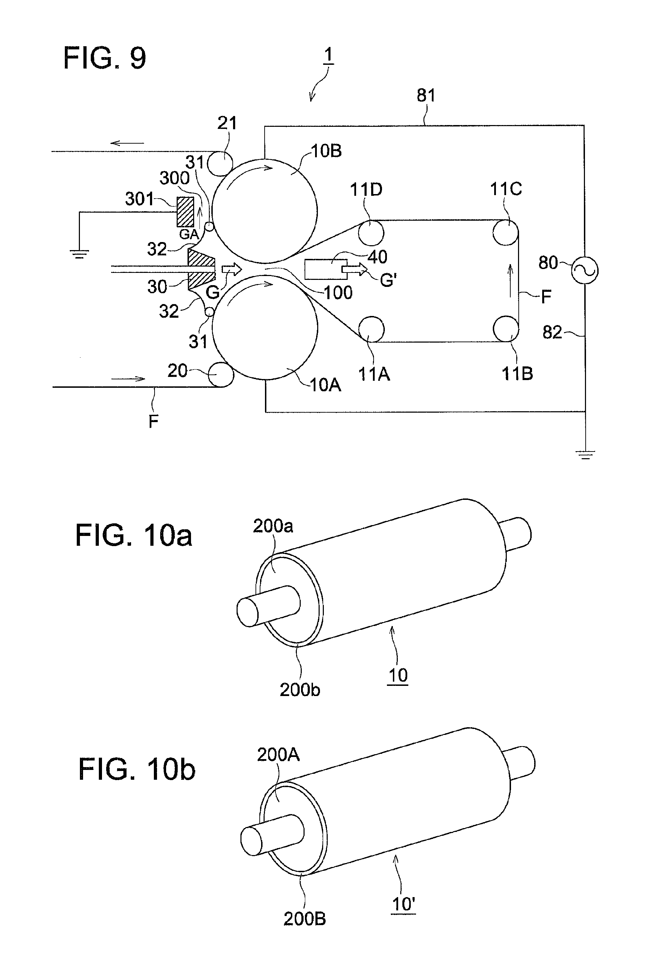

Fig. 9 shows a schematic drawing of another example of gas supplying means applicable to the plasma discharge treating apparatus relating to the invention.

The plasma discharge treating apparatus 1 shown in Fig. 9 is almost the same as that shown in Fig. 3 in the basic constitution and a constitution is newly added to the mixed gas supplying means 30. As the means for cutting the leaked mixed gas 1 (G), a nip rollers 31 having a width of equal to or wider than that of the mixed gas supplying means 30 are provided so as each to be contaced with the roller electrodes 10A and 10B, respectively; the nip roller are each rotatable accompanied with the transportation of the substrate so that the substrate F is not damaged on the occasion of contacting to the nip roller 31.

Blades each touching with the nip roller at one end and fixed on the mixed gas supplying means at the other end thereof are provided to each of the pair of the roller electrodes.

The nip roller 31 is preferably one which difficultly damage the surface of the functional thin film formed on the substrate. Hard rubber and plastics are preferably usable. In concrete, a roller made from plastics or rubber each having a rubber hardness of 60 to 80 according to JIS K 6253-1997 is preferred.

As the blade 32, one similar to the blade 32 described in Fig. 8 in the material and the shape can be applied.

The principal constitution components of the plasma discharge treating apparatus relating to the invention are described in detail below.

[Roller electrode]

Fig.10 shows a perspective view of an example of the roller electrode applicable in the invention.

The constitution of the roller electrode 10 is described below. In Fig. 10(a), the roller electrode 10 is composed of a electro-conductive mother material 200a such as a metal, hereinafter also referred to as the electrode mother material, and a ceramic coated dielectric material 200b covering the above mother material, hereinafter also simply referred to as dielectric material, which is prepared by sputtering ceramics onto the mother material and subjecting a sealing treatment. As the ceramics to be used for sputtering, alumina and silicon nitride are preferably used, and among them, alumina is more preferably used since that is easily processed.

Moreover, the roller electrode 10' may be constituted by a combination of the electro-conductive mother material 200A such as a metal and a lining treated dielectric material 200B covering the mother material, which is prepared by lining an inorganic material layer. As the lining material, silicate type glass, borate type glass, phosphate type glass, germinate type glass, tellurite type glass, aluminate type glass and vnadate type glass are preferably used, and among them, borate type glass is more preferably used since that is easily processed.

As the metal material for the electro-conductive mother material 200a and 200A, silver, platinum, stainless steel, aluminum and iron are cited, and stainless steel is preferred from the viewpoint of easily processing.

It is preferable that the each of the roller electrodes 10 is controlled in the temperature by heating or cooling according to necessity. For example, the temperature of roller electrode surface and that of the substrate are controlled by supplying liquid to the interior of the roller electrode. As the material for donating temperature, insulation material such as distilled water and oil is preferable. The temperature of the substrate is preferably controlled to be within the range of from room temperature to 200 °C in usual, and more preferably from room temperature to 120 °C, though it may be varied according to the treatment conditions.

The surface of the roller electrode requires high smoothness since the substrate is contacted to the electrode surface and transported and rotated synchronized with the electrode. The smoothness is expressed by the maximum height ($R_{max}$) of the surface roughness and the center line average surface roughness ($R_a$) prescribed by JIS B 0601. $R_{max}$ of the surface roughness of the roller electrode relating to the invention is preferably not more than 10 $\mu$m, more preferably not more than 8 $\mu$m, and particularly preferably not less than 7 $\mu$m. Ra is preferably not more than 0.5 $\mu$m, more preferably not more than 0.1 $\mu$m.

In the invention, the space between the roller electrodes is decided in consideration of the thickness of the solid dielectrics, the height of applying voltage, the application object of plasma and the shape of electrode. The distance between the electrode surfaces is preferably from 0.5 to 20 mm, more preferably from 0.5 to 5 mm, and particularly from 1 $\pm$0.5 mm for uniformly generating the plasma discharge. In the invention, the space between the roller electrodes is the distance of the roller faces facing to each other at the nearest portion. The diameter of the roller electrode is preferable from 10 to 1000 mm, more preferably from 20 to 500 mm. The peripheral speed of the roller electrode is preferably from 1 to 100 m/min, and more preferably from 5 to 50 m/min.

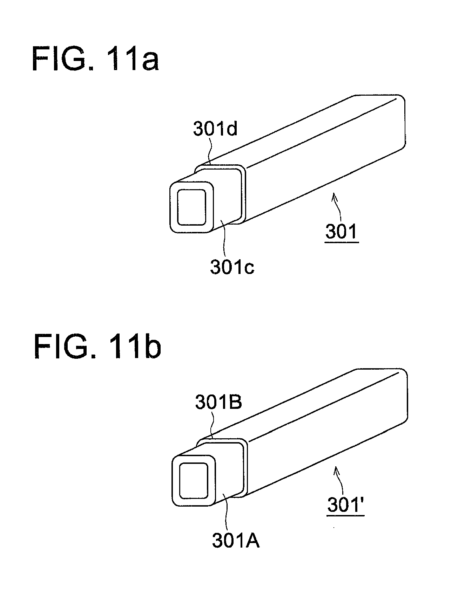

Fig. 11 displays perspective view of an example of the fixed electrode.

In Fig. 11 (a), the square pillar-shaped or square pillar-shaped hollow fix electrode 301 is constituted by the combination of the electro-conductive mother material 301c such as metal which is coated by sputtering ceramics and subjecting to sealing treatment using an inorganic material to form the ceramic coated dielectric layer 301d. Moreover, the square pillar-shaped or square pillar-shaped hollow fix electrode 301' may be constituted by a combination of the electro-conductive mother material 300A such as a metal and a lining treated dielectric material 301 B covering the mother material, which is prepared by lining an inorganic material layer, as shown in Fig. 11(b).

[Treating gas]

The treating gas to be used in the thin film forming method of the invention is described below.

In the thin film forming method of the invention, the mixed gas 1 containing the discharging gas and the thin film forming gas is used in the film forming process for forming the functional thin film on the substrate, and the mixed gas 2 containing the discharging gas and the post-treating gas is used in the post-treating process.

As the element useful for the discharging gas (also referred to as rare gas), nitrogen and elements of Group 18 in the periodic table, concretely nitrogen, helium, neon, argon, krypton, xenon and radon can be cited, and nitrogen, helium and argon are preferable in the invention, and nitrogen is particularly preferred. The concentration of the rare gas in each of the mixed gases is preferably not less than 90% by volume for stably generation of the plasma. Particularly, a concentration of from 90 to 99.9% volume is preferred. The rare gas is necessary for generating the plasma, and contributes to the surface treatment by ionizing or radicalizing the thin film forming gas during the plasma discharging.

(Thin film forming gas)

In the invention, various substances are used as the thin film forming gas according to the kind of the functional thin film to be formed on the substrate. For example, a low refractive layer useful for the antireflection layer or an anti-contamination layer can be formed by the use of a fluorine-containing organic compound, and a low refractive layer useful of the anti-reflection layer and a gas barrier layer can be formed by the use of a silicon compound. A metal oxide film or a metal nitride film can be formed by the use of an organic metal compound containing metal such as Ti, Zr, Sn, Si or Zn. By such the method, an intermediate or high refractive film useful for an anti-reflection film, and an electro-conductive film and an antistatic film can be also formed. As above-mentioned, the fluorine-containing organic compound and the metal compound are preferably used in the invention.

As the fluorine-containing organic compound preferably usable in the invention, fluorocarbon compounds such as tetrafluoromethane, hexafluoroethane, 1,1,2,2-tetafluoroethylene, 1,1,1,2,3,3-hexafluoropropane and hexafluoropropene can be cited, but the usable compound is not limited to the above. It is preferable to select the fluorine-containing compound which forms no corrosive gas or harmful gas by the plasma discharge treatment, and a condition not causing the formation of such the gases can also be selected. When the fluorine-containing organic compound is used as the reacting gas useful in the invention, the compound in gas state at the ordinary temperature and pressure is preferable since such the gas can be directly used as the reacting gas component most suitable for attaining the object. In the case of that the fluorine organic compound in liquid or solid state at the ordinary temperature and pressure, the compound can be used by vaporizing by the means such as a vaporizing apparatus by heating or pressure reducing. The compound also maybe used by spraying or vaporizing in a state of dissolved in a suitable solvent.

When the above fluorine-containing organic compound is used in the treating gas, the content of the fluorine-containing organic compound is preferably from 0.01 to 10% by volume, and more preferably from 0.1 to 5% by volume from the view point of forming the uniform thin film on the substrate by the plasma discharge. The compound may be used singly or in mixture of plural kinds.

As the metal compound preferably used in the reacting gas in the invention, a metal compound or an organic metal compound of Al, As, Au, B, Bi, Ca, Cd, Cr, Co, Cu, Fe, Ga, Ge, Hg, In, Li, Mg, Ma, Mo, Na, Ni, Pb, Pt, Rh, Sb, Se, Si, Sn, V, W, Y, Zn or Zr can be cited, and the organic metal compounds of Al, Ge, In, Sb, Si, Sn, Ti, W, Zn or Zr are preferably used.

As the organic silicon compound, for example, an alkylsilane such as dimethylsilane, tetramethylsilane, and an silicon alkoxide such as tetramethoxysilane, tetraethoxysilane, tetrapropoxysilane, dimethyldiethoxysilane, methyltrimethoxysilane and ethyltriethoxysilane; a silane hydride compound such as monosilane and disilane; a silicon halide compound such as dichlorosilane, trichlorosilane and tetrachlorosilane; and another organosilane can be cited, which are all preferably usable. In the invention, the silicon compound is not limited to the above. These compounds can be used in the suitable combination. Among the above organic silicon compound, the silicon alkoxide compounds, alkylsilane compounds and organic silicon hydride compounds are preferable from the viewpoint of easily handling, and the silicon alkoxide compounds are preferable as the organic silicon compounds since the corrosive or harmful gas is not formed and the contamination in the processing is inhibited.

As the metal compound other than the silicon useful as the reacting gas in the invention, an organic metal compound, metal halide compound and metal hydrogen compound can be cited without specific limitation. As the organic moiety of the organic metal compound, an alkyl group, an alkoxide group and an amino group are preferable, and tetraethoxytitane, tetraisoproxytitane, tetrabutoxytitane, tetradimethylaminotitane are preferably cited. As the metal halide compound, titanium dichloride, titanium trichloride and titanium tetrachloride can be cited. As the metal hydrogen compound, monotitane and dititane are cited. In the invention, the titanium type organic metal compounds can be preferably usable.

The organic metal compound to be introduced into the discharging portion may be one having any state of gas, liquid or solid at ordinary temperature and pressure. When the compound is liquid or solid, the compound can be used after vaporized by a means such as a vaporizing apparatus by applying heat, reduced pressure or ultrasonic irradiation, for example. In the invention, it is preferable to convert to the state by vaporization or evaporation. The organic metal compound in liquid state at ordinary temperature and pressure having a boiling point of not more than 200 °C is suitable for forming the thin film of the invention because such the compound can be easily vaporized. When the organic metal compound is metal alkoxide such as tetraethoxysilane or tetraisopropoxytitane, these compounds may be used dissolving in an organic solvent such as methanol, ethanol and n-hexane because they are easily dissolvable in the organic solvent. The solvent may be a mixture of solvents.

When the organic metal compound is used as the reacting gas in the treating gas, the content in the treating gas is preferably from 0.01 to 10% by volume, and more preferably 0.1 to 5% by volume. The above metal compound may be in combination of the same or different kinds of the compound.

Hydrogen, oxygen, nitrogen, nitrogen monoxide, nitrogen dioxide, carbon dioxide, ozone or hydrogen peroxide may be added into the organic fluoro compound or the reacting gas of one of these compounds in a ratio of from 0.1 to 10% by volume of the rare gas. When such the gas is used as the assistant ags, the strength of the thin film can be considerably raised.

When the substrate applied in the invention is a film having the antireflection film, the organic silicon compound is suitable for forming the low refractive film and the titanium type organic metal compound is suitable for forming the high refractive film. Both of them are preferably used. The medium refractive film also can be formed by mixing them by controlling the refractive index can be controlled by varying the mixing ratio.

Regarding the low or high refractive film formed by the plasma discharge treatment using the above treating gas, it is considered that the film is mainly composed of the oxide of the metal. For example, in the stack of the low refractive film formed from the organic silicon compound and the high refractive film formed from the organic titanium compound are each preferably contains silicon oxide and titanium oxide, respectively, as the principal ingredient. In such the case, a slight amount of silicon oxide may be contained in the high refractive film principally composed of titanium oxide. On the other hqand, a slight amount of titanium oxide may be contained in the low refractive film principally composed of silicon oxide. The contacting (adhering) ability of each of the films can be improved by such the mixing. Of course, the organic metal compound or the organic fluoro compound other than the principal ingredient may be added and mixed to the treating gas for adjusting to the objective refractive index or another purpose. The assistant gas is preferably mixed with treating gas at the step before the treating gas is supplied from the treating gas supplying means. As the above-mentioned, the discharging portion is filled by the treating gas, and the influence of a slight amount of air (oxygen and nitrogen) or moisture can be practively ignored even if a little amount of accompanied air is entered into the treating chamber. In some cases, air (oxygen or nitrogen) or moisture is intentionally added to the treating gas according to the treatment condition.

[post-treating gas]

When the metal oxide film is formed as the final functional film, an oxidizing gas is used for the treating gas in the post-treating process relating to the invention. As the oxidizing gas to be used in the invention, oxygen, ozone, hydrogen peroxide and carbon dioxide can be cited. As the discharging gas in such the case, gas selected from helium, argon and nitrogen is usable. The concentration of the oxidizing gas in the mixed gas 2 composed of the oxidizing gas and the discharging gas is preferably from 0.0001 to 30% , more preferably from 0.001 to 15%, and particularly from 0.01 to 10% by volume. The optimum concentration of each the oxidizing gas and the discharging gas can be suitably decided according to the temperature of substrate, the number of treating time and the time for treating. Oxygen and carbon dioxide are preferable as the oxidizing gas, and oxygen is more preferable.

When the metal film is formed as the final functional film, a reducing gas is used for the treating gas in the post-treating process relating to the invention. As the reducing gas, hydrogen, a hydrocarbon such as methane and water can be cited. The reducing gas is preferably used in a ratio of from 0.0001 to 10%, and more preferably from 0.001 to 5%, by volume to 100% by volume of the whole mixed gas.

[Substrate]

The substrate relating to the invention is described below.

As the substrate relating to the invention, cellulose ester film, polyester film, polycarbonate film, polystyrene film, polyolefin film, poly(vinyl alcohol) type film, cellulose type film and another film can be cited. Examples of the cellulose ester film include cellulose diacetate film, cellulose acetate butylate film, cellulose acetate propionate film, cellulose acetate phthalate film, cellulose triacetate film, cellulose nitrate; those of the polyester film include poly(ethylene terephthalate film, poly(ethylene naphthalate) film, poly(butylene naphthalate) film, 1,4-dimethylenecyclohexylene terephthalate or film of a copolymer composed of the above constitution units; those of the polycarbonate film include polycarbonate film ofbisphenol A; those of polystyrene film include sydiotactic polystyrene film; those of olefin film include polyethylene film and polypropylene film; those of the poly(vinyl alcohol) film include poly(vinyl alcohol film and etylenevinyl alcohol film; those of cellulose type film include cellophane; and those of the other resin film include norbornene type resin film, polymethylpentene film, polyetherketone film, polyimide film, polyethersulfone film, polyetherketone film, polyamide film, fluororesin film, nylon film, poly(methyl methacrylate) film, acryl film, polyallylate film and poly(vinylidiene chloride film.

Film produced by suitably mixing the materials composing the above films can be also preferably used. For example, film containing resin available on the market such as Zeonex manufactured by Nippon Zeon Corp. and Arton manufactured by JSR Corp., can be used. The substrate suitable for the invention can be obtained by optimally setting the conditions such as those of the solution-cast, molten-extrusion and stretching in the length and width direction even when the material having high refractive index such as polycarbonate, polyallylate, polysulfone and polyethersulfone is used. In the invention, the substrate is not limited to the above-described films.

The substrate thickness suitable for the plasma discharge treating apparatus for the thin film forming method of the invention is preferably within the range of approximately from 10 to 1,000 $\mu$m, and more preferably from 10 to 200 $\mu$m, and a thin substrate having a thickness of from 10 to 60 $\mu$m is preferably usable.

[Thin film, film stack and film]

In the invention, the formation of thin film is carried out by subjecting the substrate to the plasma discharging treatment using the above treating gas under the atmospheric or near atmospheric pressure. The plasma discharging treatment under the atmospheric or near atmospheric pressure in the invention can be applied to the substrate having a considerably large width such as 2,000 mm, and a processing speed of 100 m/min can be also applied. In the invention, it is preferable that firstly the treating gas or the rare gas is introduced into the treatment chamber while sucking the air in the treating chamber by a vacuum pump on the occasion of starting the plasma discharge to replace air, and then the treating gas is supplied to the discharging portion to fill the discharging portion. After that the substrate is transported and treated.

The film thickness can be suitably controlled by the discharging portion, the concentration of the treating gas and the transporting speed.

Though the thin film produced by the plasma discharge treating apparatus relating to the invention is formed on only one side, the substrate may be passed through the apparatus after winding up for subjecting to the plasma discharge treatment on the other side of the substrate. When the antistatic film is formed by the metal oxide, the antistatic film or the electro-conductive film can be formed by coating a coating liquid of the metal oxide fine particles or cross-linked cationic polymer particles on the substrate to form a thin film having a layer thickness of from approximately 0.1 to 5 $\mu$m. The thin electro-conductive film can be also formed by the plasma discharge treating apparatus relating to the invention. For example, the electro-conductive thin film of tin oxide, indium oxide or zinc oxide may be formed. Furthermore, the easily adhering ability donation process described on JP-A-2002-82223 and the antistatic property donation process described in JP-A-2000-80043 can be carried out by using the plasma discharge treating apparatus of the invention.

Though the thin film forming conditions of the plasma discharge treating apparatus relating to the invention are described in the foregoing description of the plasma discharge treating apparatus, another condition for the treatment is described below.

When the film stack of the invention is formed, it is a preferable method that the substrate is previously heated at a temperature of from 50 to 120 °C and then subjected to the plasma discharge treatment since the uniform thin film can be easily formed by such the preheating. The moisture absorbed by the substrate is dried by the heating; and the substrate is preferably subjected to the plasma discharge treatment while keeping the low moisture state. It is preferable that the substrate conditioned at a relative humidity of less than 60%, more preferably less than 40%, is subjected to the plasma discharging treatment without any moistening. The moisture content is preferably not more than 3%, more preferably not more than 2%, and further preferably not more than 1 %.

It is effectual means that the substrate after the plasma discharging treatment is subjected to a heat treatment for a time of from 1 to 30 minutes in a heating zone of 50 to 130 °C; the thin film can be stabilized by such the heating treatment.

When the thin film stack is formed by the multistep plasma discharging treatment relating to the invention, the treated surface after each of the plasma discharging treatments may be irradiated by UV rays; the contacting (adhesiveness) of the formed thin layer to the substrate and the stability can be improved by such the irradiation. The irradiating amount of UV rays is preferably from 50 to 2,000 mJ/cm$^2$. When the irradiation amount is less than 50 mJ/cm$^2$, the effect is insufficient, and irradiation of more than 2,000 mJ/cm$^2$ causes probability of deformation.

The thickness of the thin film stack formed in the invention is preferably within the range of from 1 to 1,000 nm.

The deviation of the film thickness from the average film thickness formed by the plasma discharge treating apparatus of the invention is small, and the method is excellent for forming the uniform film. The thin film having a thickness deviation of $\pm 10\%$ can be easily obtained, and the uniform film preferably having a deviation of $\pm 5\%$, and particularly $\pm 1\%$, can be obtained.

The thin film with uniform thickness can be formed by the plasma discharging treatment on a functional film having a roughened surface having a Ra of from about 0.1 to 0.5 such as an antiglare film prepared by coating and drying a coating composition containing inorganic or organic fine particles on the substrate. For example, an optical interference film can be formed when the thin film is the low or high refractive thin film.

Examples of the thin film stack of the invention, include an antireflection film, an antiglare-anti reflection film, an electromagnetic radiation sealing film, an electro-conductive layer, an antistatic film, a retardation film, an optical compensation film, a visual field expanding film and a brightness intensifying film without any limitation.

**EXAMPLES**

The invention is described below referring examples, but the invention is not limited thereto. In the examples, the expression of 'part' and '%' are means 'part by weight' and '% by weight' , respectively, unless any notice is not attached.

Example 1

<<Preparation of thin film stack>>

[Preparation of Thin Film stack 1: Invention]

[Film forming process]

Rolled poly(ethylene terephthalate) film with a thickness of 100 $\mu$m as the substrate F was twice passed through the discharging space 100 of the atmospheric pressure plasma discharge treating apparatus shown in Fig. 5 (the film forming process: voltage applying system B using the electric field generated by overlapping the first electric field and the second electric field, the post-treating process: voltage applying system A using the single power source only) having the gas supplying means 30 shown in Fig. 8 under the following discharging conditions to form a functional thin film (an antireflection film) having a thickness of 100 nm.

The roller electrodes 10A and 10B were each prepared by using a mother material of jacket roller made from titanium ally T64 having a cooling means by cooling water, on which a high density and high adhesive alumina film was spattered by a atmospheric plasma method to cover the surface and to make the roller diameter to 1,000 mm. The roller rotatable electrodes were heated and maintained at 80 °C during the plasma discharge.

(Film forming condition)

<Condition of gas>
Discharging gas: Nitrogen gas                    95.8% by volume
Film forming gas: Tetramethoxysilane (TMOS) (vaporized with nitrogen gas by a vaporizer
manufactured by Lintec Corp.)                    0.3% by volume
Additional gas: Hydrogen gas                    4.0% by volume
<Condition of power source>
First electrode side:
Kind of power source:
High frequency power source manufactured by Oyo Denki Co., Ltd.
Frequency: 80 kHz
Output density: 8 W/cm$^2$
Second electrode side:
Kind of power source:
High Frequency power source manufactured by Pearl Kogyo Co., Ltd.
Frequency: 13.56 kHz
Output density: 7 W/cm$^2$
(UV treatment)

On the occasion of the film formation, the first functional thin film formed on the substrate F in the film forming process was irradiated by UV ray between the turning rollers 11B and 11C. The irradiation amount of the UV rays was 500 mJ/cm$^2$.

[Post-treating process]

After formation of the functional thin film on the substrate F in the above film forming process, the thin film was continuously subjected to the post-treatment in the post-treatment process provided on the roller electrode 10B to prepare Thin Film Stack 1.

The roller electrode 302 was prepared by using a mother material of jacket roller made from titanium ally T64 having a cooling means by cooling water, on which a high density and high adhesive alumina film was spattered by a atmospheric plasma method to cover the surface and to make the roller diameter to 200 mm. The roller rotatable electrode was heated and maintained at 80 °C during the plasma discharge.

(Post-treating condition)

<Condition of gas>
Discharging gas: Argon gas                                    96.0% by volume
Post-treating gas: Water                                      4.0% by volume
<Condition of power source
Roller electrode 10B (Second electrode side):
Kind of power source:
High frequency power source manufactured by Pearl Kogyo Co., Ltd
Frequency: 13.56 kHz
Output density: 7 W/cm$^2$

[Preparation of Thin Film Stack 2: Invention]

[Film forming process]

Rolled poly(ethylene terephthalate) film with a thickness of 100 $\mu$m as the substrate F was twice passed through the discharging space 100 of the atmospheric pressure plasma discharge treating apparatus shown in Fig. 4 (the film forming process: voltage applying system B, the post-treating process: voltage applying system B) having the gas supplying means 30 shown in Fig. 9 under the following discharging conditions to form a functional thin film (an antireflection film) having a thickness of 100 nm.

The roller electrodes 10A and 10B were each prepared by using a mother material of jacket roller made from titanium ally T64 having a cooling means by cooling water, on which a high density and high adhesive alumina film was spattered by a atmospheric plasma method to cover the surface and to make the roller diameter to 1,000 mm. The roller rotatable electrodes were heated and maintained at 80 °C during the plasma discharge.

(Film forming condition)

<Condition of gas>
Discharging gas: Nitrogen gas                                95.8% by volume
Film forming gas: Tetramethoxysilane (TMOS) (vaporized with nitrogen gas by a vaporizer
manufactured by Lintec Corp.)                                0.3 % by volume
Additional gas: Hydrogen gas                                 4.0% by volume
<Condition of power source>
First electrode side:
Kind of power source:
High frequency power source manufactured by Oyo Denki Co., Ltd.
Frequency: 80 kHz
Output density: 8 W/cm$^2$
Second electrode side:
Kind of power source:

(continued)

<Condition of gas>
High frequency power source manufactured by Pearl Kogyo Co., Ltd.
Frequency: 13.56kHz
Output density: 7 W/cm$^2$

[Post-treatment process]

After formation of the functional thin film on the substrate F in the above film forming process, the thin film was continuously subjected to the post-treatment in the post-treatment process provided on the roller electrode 10B to prepare Thin Film Stack 2.
The square pillar-shaped hollow electrode 301 was prepared by using a square pillar-shaped hollow material made from titanium ally T64, on which dielectrics layer of 1 mm the same as above was formed under the same condition to cover the surface. The size of discharging area of the square pillar-shaped hollow electrode was 150 cm in the width direction and 4 cm in the transporting direction.

(Post-treating condition)

<Condition of gas>
Discharging gas: Nitrogen gas                                      96.0% by volume
Post-treating gas: Hydrogen gas                                    4.0% by volume
<Condition of power source>
Roller electrode 10B (Second electrode side):
Kind of power source:
High frequency power source manufactured by Pearl Kogyo Co., Ltd.
Frequency: 13.56 kHz
Output density: 18 W/cm$^2$
Square pillar-shaped hollow electrode 301:
Kind ofpower source:
High frequency power source manufactured by Oyo Denki Co., Ltd.
Frequency: 80 kHz
Output density: 20 W/cm$^2$

[Preparation of Thin Film Stack 3: Invention]

Rolled poly(ethylene terephthalate) film with a thickness of 100 μm as the substrate F was twice passed through the discharging space 100 of the atmospheric pressure plasma discharge treating apparatus shown in Fig. 5 (the film forming process: voltage applying system B, the post-treating process: voltage applying system A) having the gas supplying means 30 shown in Fig. 7 under the following discharging conditions to form a functional thin film (an antireflection film) having a thickness of 100 nm.
The roller electrodes 10A and 10B were each prepared by using a mother material of jacket roller made from titanium ally T64 having a cooling means by cooling water, on which a high density and high adhesive alumina film was spattered by a atmospheric plasma method to cover the surface and to make the roller diameter to 1,000 mm. The roller rotatable electrodes were heated and maintained at 80 °C during the plasma discharge.

(Film forming condition)

<Condition of gas>
Discharging gas: Nitrogen gas                                      95.8% by volume
Film forming gas: Tetraethoxysilane (TEOS)

(continued)

<Condition of gas>
(vaporized with nitrogen gas by a vaporizer manufactured by Lintec Corp.)   0.3% by volume
Additional gas: Hydrogen gas                                                  4.0% by volume
<Condition of power source>
First electrode side:
Kind of power source:
High frequency power source manufactured by Oyo Denki Co., Ltd.
Frequency: 80 kHz
Output density: 8 W/cm$^2$
Second electrode side:
Kind of power source:
High frequency power source manufactured by Pearl Kogyo Co., Ltd.
Frequency: 13.56 kHz
Output density: 7 W/cm$^2$

[Post-treatment process]

After formation of the functional thin film on the substrate F in the above film forming process, the thin film was continuously subjected to the post-treatment in the post-treatment process provided on the roller electrode 10B to prepare Thin Film Stack 3.

The roller electrode 302 was prepared by using a mother material of jacket roller made from titanium ally T64 having a cooling means by cooling water, on which a high density and high adhesive alumina film was spattered by a atmospheric plasma method to cover the surface and to make the roller diameter to 200 mm. The roller rotatable electrode was heated and maintained at 80 °C during the plasma discharge.

(Post treating condition)

<Condition of gas>
Discharging gas: Nitrogen gas                                                96.0% by volume
Post-treating gas: Oxygen gas                                                 4.0% by volume
<Condition of power source>
Roller electrode 10B (Second electrode side)
Kind of power source:
High frequency power source manufactured by Pearl Kogyo Co., Ltd.
Frequency: 13.56 kHz
Output density: 7 W/cm$^2$

[Preparation of Thin Film Stack 4: Invention]

Rolled poly(ethylene terephthalate) film with a thickness of 100 $\mu$m as the substrate F was twice passed through the discharging space 100 of the atmospheric pressure plasma discharge treating apparatus shown in Fig. 5 (the film forming process: voltage applying system B, the post-treating process: voltage supplying system B) having the gas supplying means 30 shown in Fig. 8 under the following discharging conditions to form a functional thin film (an antireflection film) having a thickness of 100 nm.

The roller electrodes 10A and 10B were each prepared by using a mother material or jacket roller made from titanium ally T64 having a cooling means by cooling water, on which a high density and high adhesive alumina film was spattered by a atmospheric plasma method to cover the surface and to make the roller diameter to 1,000 mm. The roller rotatable electrodes were heated and maintained at 80 °C during the plasma discharge.

(Film forming condition)

<Condition of gas>
Discharging gas: Nitrogen gas                                    95.8% by volume
Film forming gas: Tetraethoxysilane (TEOS)
(vaporized with nitrogen gas by a vaporizer manufactured by Lintec Corp.)
                                                                0.3% by volume
Additional gas: Hydrogen gas                                     4.0% by volume
<Condition of power source>
First electrode side:
Kind of power source:
High frequency power source manufactured by Oyo Denki Co., Ltd.
Frequency: 80 kHz
Output density: 4 W/cm$^2$
Second electrode side:
Kind of power source:
High frequency power source manufactured by Pearl Kogyo Co., Ltd.
Frequency: 13.56kHz
Output density: 3 W/cm$^2$

(UV treatment)

On the occasion of the film formation, the first functional thin film formed on the substrate F in the film forming process was irradiated by UV ray between the turning rollers 11B and 11C. The irradiation amount of the UV rays was 500 mJ/cm$^2$.

[Post-treating process]

After formation of the functional thin film on the substrate F in the above film forming process, the thin film was continuously subjected to the post-treatment in the post-treatment process provided on the roller electrode 10B to prepare Thin Film Stack 4.
The roller electrode 302 was prepared by using a mother material of jacket roller made from titanium ally T64 having a cooling means by cooling water, on which a high density and high adhesive alumina film was spattered by a atmospheric plasma method to cover the surface and to make the roller diameter to 200 mm. The roller rotatable electrode was heated and maintained at 80 °C during the plasma discharge.

(Post-treating condition)

<Condition of gas>
Discharging gas: Argon gas                                       96.0% by volume
Post-treating gas: Water                                         4.0% by volume
<Condition of power source>
Roller electrode 10B (Second electrode side):
Kind of power source:
High frequency power source manufactured by Pearl Kogyo Co., Ltd.
Frequency: 13.56 kHz
Output density:18 W/cm$^2$
Roller electrode 302 side
Kind of power source:
High frequency power source manufactured by Oyo Denki Co., Ltd.

(continued)

<Condition of gas>
Frequency: 80 kHz
Output density: 20 W/cm$^2$

[Preparation of Thin Film Stack 5: Invention]

Rolled poly(ethylene terephthalate) film with a thickness of 100 $\mu$m as the substrate F was twice passed through the discharging space 100 of the atmospheric pressure plasma discharge treating apparatus shown in Fig. 4 (the film forming process: voltage applying system B, the post-treating process: voltage supplying system B) having the gas supplying means 30 shown in Fig. 7 under the following discharging conditions to form a functional thin film (an antireflection film) having a thickness of 100 nm.

The roller electrodes 10A and 10B were each prepared by using a mother material of jacket roller made from titanium ally T64 having a cooling means by cooling water, on which a high density and high adhesive alumina film was spattered by a atmospheric plasma method to cover the surface and to make the roller diameter to 1,000 mm. The roller rotatable electrodes were heated and maintained at 80 °C during the plasma discharge.

(Film forming condition)

<Condition of gas>
Discharging gas: Nitrogen gas                                    95.8% by volume
Film forming gas: Hexamethyldisiloxane (HMDSO)
(vaporized with nitrogen gas by a vaporizer manufactured by Lintec Corp.)
                                                                 0.3% by volume
Additional gas: Hydrogen gas                                     4.0% by volume
<Condition of power source>
First electrode side:
Kind of power source:
High frequency power source manufactured by Oyo Denki Co., Ltd.
Frequency: 80 kHz
Output density: 4 W/cm$^2$
Second electrode side:
Kind of power source:
High frequency power source manufactured by Pearl Kogyo Co., Ltd.
Frequency: 13.56 kHz
Output density: 3 W/cm$^2$

[Post-treating process]

After formation of the functional thin film on the substrate F in the above film forming process, the thin film was continuously subjected to the post-treatment in the post-treatmentprocess provided on the roller electrode 10B to prepare Thin Film Stack 5.

The square pillar-shaped hollow electrode 301 was prepared by using a square pillar-shaped hollow material made from titanium ally T64, on which dielectrics layer of 1 mm the same as above was formed under the same condition to cover the surface. The size of discharging area of the square pillar-shaped hollow electrode was 150 cm in the width direction and 4 cm in the transporting direction.

(post-treating condition)

<Condition of gas>
Discharging gas: Nitrogen gas                96.0% by volume
Post-treating gas: Hydrogen gas              4.0% by volume
<Condition of power source>
Roller electrode 10B (Second electrode side):
Kind of power source:
High frequency power source manufactured by Pearl Kogyo Co., Ltd.
Frequency: 13.56 kHz
Output density: 18 W/cm$^2$
Roller electrode 302 side
Kind of power source:
High frequency power source manufactured by Oyo Denki Co., Ltd.
Frequency: 80 kHz
Output density: 20 W/cm$^2$

[Preparation of Thin Film Stack 6: Invention]

Rolled poly(ethylene terephthalate) film with a thickness of 100 $\mu$m as the substrate F was twice passed through the discharging space 100 of the atmospheric pressure plasma discharge treating apparatus shown in Fig. 4 (the film forming process: voltage applying system B, the post-treating process: voltage supplying system B) having the gas supplying means 30 shown in Fig. 7 under the following discharging conditions to form a functional thin film (an antireflection film) having a thickness of 100 nm.

The roller electrodes 10A and 10B were each prepared by using a mother material of jacket roller made from titanium ally T64 having a cooling means by cooling water, on which a high density and high adhesive alumina film was spattered by a atmospheric plasma method to cover the surface and to make the roller diameter to 1,000 mm. The roller rotatable electrodes were heated and maintained at 80 °C during the plasma discharge.

(Film forming condition)

<Condition of gas>
Discharging gas: Nitrogen gas                                95.8% by volume
Film forming gas: Hexamethyldisiloxane (HMDSO)
(vaporized with nitrogen gas by a vaporizer manufactured by Lintec Corp.)
                                                             0.3% by volume
Additional gas: Hydrogen gas                                 4.0% by volume
<Condition of power source>
First electrode side:
Kind of power source:
High frequency power source manufactured by Oyo Denki Co., Ltd.
Frequency: 80 kHz
Output density: 4 W/cm$^2$
Second electrode side:
Kind of power source:
High frequency power source manufactured by Pearl Kogyo Co., Ltd.
Frequency: 13.56 kHz
Output density: 3 W/cm$^2$

[Post-treating process]

After formation of the functional thin film on the substrate F in the above film forming process, the thin film was continuously subjected to the post-treatment in the post-treatment process provided on the roller electrode 10B to prepare Thin Film Stack 6.

The square pillar-shaped hollow electrode 301 was prepared by using a square pillar-shaped hollow material made from titanium ally T64, on which dielectrics layer of 1 mm the same as above was formed under the same condition to cover the surface. The size of discharging area of the square pillar-shaped hollow electrode was 150 cm in the width direction and 4 cm in the transporting direction.

(Post-treating condition)

| | |
|---|---|
| <Condition of gas> | |
| Discharging gas: Argon gas | 96.0% by volume |
| Post-treating gas: Oxygen gas | 4.0% by volume |
| <Condition of power source> | |
| Roller electrode 10B (Second electrode side): | |
| Kind of power source: | |
| High frequency power source manufactured by Pearl Kogyo Co., Ltd. | |
| Frequency. 13.56 kHz | |
| Output density: 7 W/cm$^2$ | |

[Preparation of Thin Film Stack 7: Invention]

Thin Film Stack 7 was prepared in the same manner as in the preparation of Thin Film Stack 2, except that the double loop type atmospheric pressure plasma discharge treating apparatus (the film forming process: voltage applying system B, the post-treating process: voltage applying system A) shown in Fig. 2 was used in place of the atmospheric pressure plasma discharge treating apparatus (the film forming process: voltage applying system B, the post-treating process: voltage applying system A) shown in Fig. 5.

[Preparation of Thin Film Stack 8: Invention]

Thin Film Stack 8 was prepared in the same manner as in the preparation of Thin Film Stack 3, except that the loop type atmospheric pressure plasma discharge treating apparatus (the film forming process: Voltage applying system B, the post-treating process: Voltage applying system B) shown in Fig. 6 was used in place of the atmospheric pressure plasma discharge treating apparatus (the film forming process: Voltage applying system B, the post-treating process: Voltage applying system B) shown in Fig. 4

[Preparation of Thin Film Stack 9: Comparison]

Thin Film Stack 9 was prepared by the following film forming process only.

[Film forming process]

Rolled poly(ethylene terephthalate) film with a thickness of 100 μm as the substrate F was twice passed through the discharging space 100 of the atmospheric pressure plasma discharge treating apparatus shown in Fig. 5 (the film forming process: voltage applying system B) having the gas supplying means 30 shown in Fig. 7 under the following discharging conditions to form a functional thin film (an antireflection film) having a thickness of 100 nm to prepare Thin Film Stack 9..

The roller electrodes 10A and 10B were each prepared by using a mother material of jacket roller made from titanium ally T64 having a cooling means by cooling water, on which a high density and high adhesive alumina film was spattered by a atmospheric plasma method to cover the surface and to make the roller diameter to 1,000 mm. The roller rotatable electrodes were heated and maintained at 80 °C during the plasma discharge.

(Film forming condition)

<Condition of gas>
Discharging gas: Nitrogen gas                                                    95.8% by volume
Film forming gas: Hexamethyldisiloxane (HMDSO)
(vaporized with nitrogen gas by a vaporizer manufactured by Lintec Corp.)
                                                                                0.3% by volume
Additional gas: Hydrogen gas                                                     4.0% by volume
<Condition of power source>
First electrode side:
Kind of power source:
High frequency power source manufactured by Oyo Denki Co., Ltd.
Frequency: 80 kHz
Output density: 20 W/cm$^2$
Second electrode side:
Kind of power source:
High frequency power source manufactured by Pearl Kogyo Co., Ltd.
Frequency: 13.56 kHz
Output density: 18 W/cm$^2$

(UV treatment)

On the occasion of the film formation, the first functional thin film formed on the substrate F in the film forming process was irradiated by UV ray between the turning rollers 11B and 11C. The irradiation amount of the UV rays was 500 mJ/cm$^2$.

[Preparation of Thin Film Stack 10: Comparison]

Thin Film Stack 10 was prepared by the following film forming process only.

[Film forming process]

Rolled poly(ethylene terephthalate) film with a thickness of 100 $\mu$m as the substrate F was twice passed through the discharging space 100 of the atmospheric pressure plasma discharge treating apparatus shown in Fig.1 (the film forming process: voltage applying system A) having the gas supplying means 30 shown in Fig. 9 under the following discharging conditions to form a functional thin film (an antireflection film) having a thickness of 100 nm to prepare Thin Film Stack 10..
The roller electrodes 10A and 10B were each prepared by using a mother material of jacket roller made from titanium ally T64 having a cooling means by cooling water, on which a high density and high adhesive alumina film was spattered by a atmospheric plasma method to cover the surface and to make the roller diameter to 1,000 mm. The roller rotatable electrodes were heated and maintained at 80 °C during the plasma discharge.

(Film forming condition)

<Condition of gas>
Discharging gas: Nitrogen gas                                                    95.8% by volume
Film forming gas: Tetramethoxysilane (TMOS)
(vaporized with nitrogen gas by a vaporizer manufactured by Lintec Corp.)        0.3% by volume
Additional gas: Hydrogen gas                                                     4.0% by volume
<Condition of power source>
Kind of power source:
High frequency power source manufactured by Pearl Kogyo Co., Ltd.
Frequency: 13.56 kHz
Output density: 18 W/cm$^2$

[Preparation of Thin Film Stack 11: Comparison]

Thin Film Stack 11 was prepared by the following film forming process only.

[Film forming process]

Rolled poly(ethylene terephthalate) film) with a thickness of 100 $\mu$m as the substrate F was twice passed through the discharging space 100 of the atmospheric pressure plasma discharge treating apparatus shown in Fig.1 1 (the film forming process: voltage applying system A) having the gas supplying means 30 shown in Fig. 7 under the following discharging conditions to form a functional thin film (an antireflection film) having a thickness of 100 nm to prepare Thin Film Stack 11..

The roller electrodes 10A and 10B were each prepared by using a mother material of jacket roller made from titanium ally T64 having a cooling means by cooling water, on which a high density and high adhesive alumina film was spattered by a atmospheric plasma method to cover the surface and to make the roller diameter to 1,000 mm. The roller rotatable electrodes were heated and maintained at 80 °C during the plasma discharge.

(Film forming condition)

<Condition of gas>
Discharging gas: Argon gas                                              95.8% by volume
Film forming gas: Tetraethoxysilane (TMOS)
(vaporized with nitrogen gas by a vaporizer manufactured by Lintec Corp.)
                                                                       0.3% by volume
Additional gas: Hydrogen gas                                            4.0% by volume
<Condition of power source>
Kind of power source:
High frequency power source manufactured by Pearl Kogyo Co., Ltd.
Frequency: 13.56 kHz
Output density: 8 W/cm$^2$

[Preparation of Thin Film Stack 12: Comparison]

[Film forming process]

Rolled poly(ethylene terephthalate) film with a thickness of 100 $\mu$m as the substrate F was twice passed through the discharging space 100 of the atmospheric pressure plasma discharge treating apparatus shown in Fig. 1 (the film forming process: voltage applying system A) in which the voltage applying system in the post-treating process was changed to the system B under the following discharging conditions to form a functional thin film (an antireflection film) having a thickness of 100 nm to prepare Thin Film Stack 12.

The roller electrodes 10A and 10B were each prepared by using a mother material of jacket roller made from titanium ally T64 having a cooling means by cooling water, on which a high density and high adhesive alumina film was spattered by a atmospheric plasma method to cover the surface and to make the roller diameter to 1,000 mm. The roller rotatable electrodes were heated and maintained at 80 °C during the plasma discharge.

(Film forming condition)

<Condition of gas>
Discharging gas: Nitrogen gas                                           95.8% by volume
Film forming gas: Tetramethoxysilane (TMOS)
(vaporized with nitrogen gas by a vaporizer manufactured by Lintec Corp.)
                                                                       0.3% by volume

(continued)

<Condition of gas>
Additional gas: Hydrogen gas                    4.0% by volume
<Condition of power source>
First electrode side:
Kind of power source:
High frequency power source manufactured by Pearl Kogyo Co., Ltd.
Frequency: 13.56 kHz
Output density: 18 W/cm$^2$

(UV treatment)

On the occasion of the film formation, the first functional thin film formed on the substrate F in the film forming process was irradiated by UV ray between the turning rollers 11B and 11C. The irradiation amount of the UV rays was 500 mJ/cm$^2$.

[Post-treating process]

After formation of the functional thin film on the substrate F in the above film forming process, the thin film was continuously subjected to the post-treatment in the post-treatment process provided on the roller electrode 10B to prepare Thin Film Stack 12.
The roller electrode 302 was prepared by using a mother material of jacket roller made from titanium ally T64 having a cooling means by cooling water, on which a high density and high adhesive alumina film was spattered by a atmospheric plasma method to cover the surface and to make the roller diameter to 200 mm. The roller rotatable electrode was heated and maintained at 80 °C during the plasma discharge.

(Post-treating condition)

<Condition of gas>
Discharging gas: Argon gas                    96.0% by volume
Post-treating gas: Water                    4.0% by volume
<Condition of power source>
Roller electrode 10B (Second electrode side):
Kind of power source:
High frequency power source manufactured by Pearl Kogyo Co., Ltd.
Frequency: 13.56 kHz
Output density: 18 W/cm$^2$
Roller electrode 302 side
Kind of power source:
High frequency power source manufactured by Oyo Denki Co., Ltd.
Frequency: 80 kHz
Output density: 20 W/cm$^2$

[Preparation of Thin Film Stack 13: Comparison]

[Film forming process]

Rolled poly(ethylene terephthalate) film with a thickness of 100 $\mu$m as the substrate F was twice passed through the discharging space 100 of the atmospheric pressure plasma discharge treating apparatus shown in Fig. 4 (the film forming process: voltage applying system A), in which the voltage applying system in the post-treating process was changed to the system B, having the gas supplying means shown in Fig. 9 under the following discharging conditions to form a functional thin film (an antireflection film) having a thickness of 100 nm to prepare Thin Film Stack 13.

The roller electrodes 10A and 10B were each prepared by using a mother material of jacket roller made from titanium ally T64 having a cooling means by cooling water, on which a high density and high adhesive alumina film was spattered by a atmospheric plasma method to cover the surface and to make the roller diameter to 1,000 mm. The roller rotatable electrodes were heated and maintained at 80 °C during the plasma discharge.

(Film forming condition)

<Condition of gas>
Discharging gas: Argon gas                                      95.8% by volume
Film forming gas: Tetraethoxysilane (TEOS)
(vaporized with nitrogen gas by a vaporizer manufactured by Lintec Corp.)
                                                               0.3% by volume
Additional gas: Hydrogen gas                                     4.0% by volume
<Condition of power source>
First electrode side:
Kind of power source:
High frequency power source manufactured by Pearl Kogyo Co., Ltd.
Frequency: 13.56 kHz
Output density: 18 W/cm$^2$

[Post-treating process]

After formation of the functional thin film on the substrate F in the above film forming process, the thin film was continuously subjected to the post-treatment in the post-treatment process provided on the roller electrode 10B to prepare Thin Film Stack 13.

The square pillar-shaped hollow electrode 301 was prepared by using a square pillar-shaped hollow material made from titanium ally T64, on which dielectrics layer of 1 mm the same as above was formed under the same condition to cover the surface. The size of discharging area of the square pillar-shaped hollow electrode was 150 cm in the width direction and 4 cm in the transporting direction.

(Post-treating condition)

<Condition of gas>
Discharging gas: Argon gas                                      96.0% by volume
Post-treating gas: Hydrogen gas                                  4.0% by volume
<Condition of power source>
Roller electrode 10B (Second electrode side):
Kind ofpower source:
High frequency power source manufactured by Pearl Kogyo Co., Ltd.
Frequency: 13.56 kHz
Output density: 18 W/cm$^2$
Roller electrode 301 side
Kind of power source:
High frequency power source manufactured by Oyo Denki Co., Ltd.
Frequency: 80 kHz
Output density: 20 W/cm$^2$

[Preparation of Thin Film Stack 14: Comparison]

Thin Film Stack 14 was prepared was prepared in the same manner as in the preparation of Thin film Stack 6 except that the post-treating process was changed as follows.

[Post-treating process]

After formation of the functional thin film on the substrate F in the above film forming process, the thin film was continuously subjected to the post-treatment in the post-treatment process provided on the roller electrode 10B to prepare Thin Film Stack 14.

[Post-treating process]

After formation of the functional thin film on the substrate F in the above film forming process, the thin film was continuously subjected to the post-treatment in the post-treatment process provided on the roller electrode 10B to prepare Thin Film Stack 14.

The roller electrode 302 was prepared by using a mother material of jacket roller made from titanium ally T64 having a cooling means by cooling water, on which a high density and high adhesive alumina film was spattered by a atmospheric plasma method to cover the surface and to make the roller diameter to 200 mm. The roller rotatable electrode was heated and maintained at 80 °C during the plasma discharge.

<Condition of gas>

| | |
|---|---|
| Discharging gas: Nitrogen gas | 96.0% by volume |
| Post-treating gas: Oxygen gas | 4.0% by volume |

<Condition of power source>
Roller electrode 10B (Second electrode side):
Kind of power source:
High frequency power source manufactured by Pearl Kogyo Co., Ltd.
Frequency: 13.56 kHz
Output density: 7 W/cm$^2$

The details of the conditions expressed by abbreviation in Table 1 are as follows.

[Transportation system]

A: Turning transportation system
B: Loop transportation system
C: Double line transportation system

[Thin film forming gas]

TMOS: Tetramethoxysilane
TEOS: Tetraethoxysilane
HMDSO: hexamethyldisiloxane

[Discharging output condition]

1: High output condition (> 15 W/cm$^2$)
2: Medium output condition (5-15 W/cm$^2$)
3: Low output condition (less than 5 W/cm$^2$)

[Voltage applying system]

Voltage applying system A: The system for applying voltage by the single power source
Voltage applying system B: The system for applying the first electric field and the second electric field in overlap

<<Evaluation of thin film stack>>

The above prepared thin film stacks were evaluated as follows.

(Measurement of film density)

The film density of each of the above prepared thin film stacks was measured by the following method and the film density property was evaluated.

(Measurement of film density)

The film density was measured by X-ray reflectance measuring method. The measuring apparatus was MXP21 manufactured by Mac Science Corp. As the target of the X-ray source, copper was used, and the apparatus was driven at 42 kV and 500 mA. A multi-layer parabolic mirror was used in the incident monochrometer. The incidental slit and the light receiving slit were each 0.05 mm x 5 mm and 0.03 mm x 20 mm, respectively. The measurement was carried out by FT method by $2\theta/\theta$ scanning from 0 to 5° at step width of 0.005° and a rate of 10 sec per step. Thus obtained reflectance curve was subjected to curve fitting using Reflectivity Analysis Program Ver. 1. Manufactured by Mac Science Corp. Parameters were decided so that the sum of square of difference between the practical measured value was made minimum and the fitting curve, and the film density was obtained from each of the parameters.

(Evaluation of film density property)

The above obtained film density and the theoretical film density of the silicon oxide film obtained by calculation were compared, and the film density property was evaluated according to the following norms.

A: The measured fihn density was within the range of from 80 to 100% of the theoretical film density.
B: The measured film density was within the range of from not less than 60% and less than 80% of the theoretical film density.
C: The measured film density was less than 50% of the theoretical film density.

(Evaluation of uniformity of thin film)

The film density was measured at optionally selected 30 points on the thin film stack, and the arithmetic average value, the maximum value and the minimum value were obtained, and then the fluctuation of the film density was calculated according to the following expression. The Calculated result was used as the scale of the uniformity of the film.

$$\text{Fluctuation width of film uniformity} = (\text{Maximum value} - \text{Minimum value})/\text{arithmetic average value} \times 100 \ (\%)$$

Thus obtained results are listed in Table 1.

Table 1

| Thin film stack No. | Plasma discharge treating apparatus | Substrate transporting system | First discharging space | | | | | UV irradiation | Second discharging space | | | | | Evaluation result | | Remarks |
|---|---|---|---|---|---|---|---|---|---|---|---|---|---|---|---|---|
| | | | Composition of mixed gas 1 | | Mixed gas supplying system | Discharging condition | | | Composition of mixed gas 2 | | Shape of electrode | Discharging condition | | *4 | *5 | |
| | | | Discharging gas | Film forming gas | | *1 | *2 | | Discharging gas | Posttreating gas | | *1 | *2 | | | |
| 1 | Fig. 5 | A | Nitrogen | TMOS | Fig.8 | B | 2 | With | Argon | Water | Roller | A | 2 | A | 2 | Inv. |
| 2 | Fig. 4 | A | Nitrogen | TMOS | Fig.9 | B | 2 | Without | Nitrogen | Hydrogen | *3 | B | 1 | A | 2 | Inv. |
| 3 | Fig. 5 | A | Nitrogen | TEOS | Fig.7 | B | 2 | Without | Nitrogen | Oxygen | Roller | A | 2 | A | 1 | Inv. |
| 4 | Fig. 5 | A | Nitrogen | TEOS | Fig.8 | B | 3 | With | Argon | Water | Roller | B | 1 | A | 2 | Inv. |
| 5 | Fig. 4 | A | Nitrogen | HMDSO | Fig.9 | B | 3 | Without | Nitrogen | Hydrogen | *3 | B | 1 | A | 1 | Inv. |
| 6 | Fig 4 | A | Nitrogen | HMDSO | Fig.7 | B | 2 | Without | Argon | Oxygen | Roller | A | 2 | A | 2 | Inv. |
| 7 | Fig. 2 | C | Nitrogen | TEOS | Fig.7 | B | 2 | Without | Nitrogen | Oxygen | Roller | A | 2 | A | 2 | Inv. |
| 8 | Fig. 6 | B | Nitrogen | TMOS | Fig.9 | B | 2 | Without | Nitrogen | Hydrogen | *3 | B | 1 | A | 2 | Inv. |
| 9 | Fig. 5 | A | Nitrogen | HMDSO | Fig.8 | B | 1 | With | - | - | - | - | - | B | 25 | Comp. |
| 10 | Fig. 1 | A | Nitrogen | TMOS | Fig.9 | A | 1 | Without | - | - | - | - | - | C | 30 | Comp. |
| 11 | Fig. 1 | A | Argon | TEOS | Fig.7 | A | 2 | Without | - | - | - | - | - | C | 20 | Comp. |
| 12 | Fig. 1 modified | A | Nitrogen | TMOS | Fig.8 | A | 1 | With | Argon | Water | Roller | B | 1 | B | 15 | Inv. |
| 13 | Fig. 4 modified | A | Argon | TEOS | Fig.9 | A | 1 | Without | Argon | Hydrogen | *3 | B | 1 | B | 15 | Inv. |
| 14 | Fig. 4 modified | A | Nitrogen | HMDSO | Fig.7 | B | 2 | Without | Nitrogen | Oxygen | Roller | A | 2 | B | 10 | Inv. |

*1: Voltage applying system, *2: Output condition, *3: Hollow square pillar, *4: Film density property
*5: Thin film uniformity(%), Inv.: Inventive, Comp.: Comparative

As is cleared in Table 1, the thin film stacks prepared by the method of the invention are higher in the film density and excellent in the uniformity of the thin film compared with the comparative samples.

**Claims**

1. A thin film forming method for forming a thin film onto a substrate by a plasma discharging treatment under atmospheric pressure or near atmospheric pressure comprising;
   a first discharging space forming a functional thin film on the substrate, and
   a second discharge space post-treating the substrate, on which formed the thin film in the first discharge space,
   the first discharge space is the thin film forming process, which is constituted by at least one pair of roller electrodes, and transports the substrate while holding by winding on the surface of each of the roller electrodes and supplies mixed gas 1 containing discharging gas and thin film forming gas into the first discharging space from a mixed gas supplying section, and generates high frequency electric field between each of the roller electrodes to form the functional film on the substrate,
   the second discharge space is the post-treatment process, which is positioned on the periphery of at least one of the roller electrodes and, introduces the substrate on which the functional film is formed, and supplies the mixed gas 2 containing the discharging gas and post-treatment gas between the facing electrodes and generates a high frequency electric field between the facing electrode and the roller electrode to perform the post-treatment.

2. The thin film forming method of claim 1, wherein the discharging gas is nitrogen.

3. The thin film forming method of claim 1 or 2, wherein the post-treatment gas in the post-treatment process is oxidizing gas to form a metal oxide film.

4. The thin film forming method of claim 1 or 2, wherein the post-treatment gas in the post-treatment process is reducing gas to form a metal film.

5. The thin film forming method of any one of claims 1 to 4, wherein the plasma discharging treatment under atmospheric pressure or near the atmospheric pressure in the first discharge space is carried out by a plasma discharging method in which a first high frequency electric field and a second high frequency electric field are overlapped between the pair of the roller electrodes.

6. The thin film forming method of any one of claims 1 to 5, wherein the plasma discharging treatment under atmospheric pressure or near the atmospheric pressure in the second discharge space is carried out by a plasma discharging method in which a first high frequency electric field and a second high frequency electric field are overlapped between the facing electrode and the roller electrode.

7. The thin film forming method of any one of claims 1 to 6, wherein the supply of the mixed gas into the first discharge space is carried out through an assistant blowing section together with the mixed gas supplying section.

8. The thin film forming method of any one of claims 1 to 6, wherein the method has a blade which is attached at a portion being between the mixed gas supplying section and the roller electrode of the first discharging space, which is touched to the outer peripheral surface of the roller electrode at one end and fixed on the mixed gas supplying section at the other end.

9. The thin film forming method of any one of claims 1 to 6, wherein the method has a rotatable nip roller which are touched each other, and has a blade which is touched to the nip roller at one end and fixed on the mixed gas supplying section at the other end to a portion being between the mixed gas supplying section of the first discharging space and the roller electrode.

10. The thin film forming method of any one of claims 1 to 9, wherein the method has a structure for changing the position of the second discharging space so that the formation of the thin film is performed by reversing the transportation direction of the substrate.

11. A film stack formed by the thin film forming method described in any one of claims 1 to 10.

# FIG. 1

# FIG. 2

# FIG. 3

# FIG. 4

EP 2 243 859 A1

# FIG. 5

EP 2 243 859 A1

FIG. 6

EP 2 243 859 A1

# FIG. 7

# FIG. 8

FIG. 9

FIG. 10a

FIG. 10b

FIG. 11a

301d

301c

301

FIG. 11b

301B

301A

301'

## INTERNATIONAL SEARCH REPORT

| | International application No. |
|---|---|
| | PCT/JP2009/050819 |

A. CLASSIFICATION OF SUBJECT MATTER
*C23C16/56*(2006.01)i, *C23C16/509*(2006.01)i, *C23C16/54*(2006.01)i

According to International Patent Classification (IPC) or to both national classification and IPC

B. FIELDS SEARCHED

Minimum documentation searched (classification system followed by classification symbols)
C23C16/56, C23C16/509, C23C16/54

Documentation searched other than minimum documentation to the extent that such documents are included in the fields searched
| | | | |
|---|---|---|---|
| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)
WPI

C. DOCUMENTS CONSIDERED TO BE RELEVANT

| Category* | Citation of document, with indication, where appropriate, of the relevant passages | Relevant to claim No. |
|---|---|---|
| X<br>Y<br>A | JP 2007-73333 A  (Konica Minolta Holdings, Inc.),<br>22 March, 2007 (22.03.07),<br>Claims 8, 12; Par. Nos. [0110] to [0116]; Fig. 8<br>(Family: none) | 1,2,5,6,11<br>3,7,10<br>4,8,9 |
| Y | WO 2005/007927 A1  (Konica Minolta Holdings, Inc.),<br>27 January, 2005 (27.01.05),<br>Claim 1<br>& US 2006/0199014 A1    & EP 1645657 A1<br>& KR 10-2006-0037241 A   & CN 1780935 A | 3 |

| ☒ | Further documents are listed in the continuation of Box C. | ☐ | See patent family annex. |
|---|---|---|---|

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 19 March, 2009 (19.03.09) | 31 March, 2009 (31.03.09) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

| International application No. |
|---|
| PCT/JP2009/050819 |

C (Continuation).   DOCUMENTS CONSIDERED TO BE RELEVANT

| Category* | Citation of document, with indication, where appropriate, of the relevant passages | Relevant to claim No. |
|---|---|---|
| Y | WO 2008/001723 A1  (Konica Minolta Holdings, Inc.), 03 January, 2008 (03.01.08), Claims 1, 2 (Family: none) | 7 |
| Y | WO 2007/026545 A1  (Konica Minolta Holdings, Inc.), 08 March, 2007 (08.03.07), Claims 1, 4 & EP 1921180 A1 | 10 |
| P,A | JP 2008-075099 A  (Konica Minolta Holdings, Inc.), 03 April, 2008 (03.04.08), Fig. 1 (Family: none) | 8,9 |

Form PCT/ISA/210 (continuation of second sheet) (April 2007)

39

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003093870 A
- JP 2004189958 A
- JP 2007087788 A
- JP 2002082223 A
- JP 2000080043 A